# EUROPÄISCHE PATENTSCHRIFT

(11) **EP 4 302 073 B1**
(45) Veröffentlichungstag und Bekanntmachung des Hinweises auf die Patenterteilung: **13.08.2025**
(21) Anmeldenummer: 22709752.4
(22) Anmeldetag: 04.03.2022
(51) Int. Cl.: G01N 21/17, G01N 29/24, B81B 7/02, B81C 1/00, G01N 21/3518

(54) **VERFAHREN ZUM EINSCHLUSS VON REFERENZGASEN IN MEMS-ZELLEN**
METHOD FOR THE INCLUSION OF REFERENCE GASES IN MEMS CELLS
PROCÉDÉ D'INCLUSION DES GAZ DE RÉFÉRENCE DANS DES CELLULES MEMS

(30) Priorität: 04.03.2021 EP 21160684
(43) Veröffentlichungstag der Anmeldung: 10.01.2024
(73) Patentinhaber: Hahn-Schickard-Gesellschaft für angewandte Forschung e. V., 70569 Stuttgart (DE)
(72) Erfinder: BITTNER, Achim, 74080 Heilbronn (DE); DEHÉ, Alfons, 72770 Reutlingen (DE); SRIVASTAVA, Ananya, 78054 Villingen-Schwenningen (DE)
(74) Vertreter: Hertin und Partner Rechts- und Patentanwälte PartG mbB
(86) Internationale Anmeldenummer: PCT/EP2022/055582
(87) Internationale Veröffentlichungsnummer: WO 2022/184906

(56) Entgegenhaltungen:
- US-A1- 2003 183 916
- US-A1- 2007 295 456
- US-A1- 2014 038 364
- US-A1- 2018 339 900
- US-A1- 2019 353 157
- US-A1- 2020 057 031
- US-A1- 2020 198 964
- US-A1- 2021 055 207

## Beschreibung

Die Erfindung betrifft in einem ersten Aspekt ein Herstellungsverfahren einer mit Gas gefüllten Referenzkammer, welche hermetisch abgeriegelt ist. Dabei wird das Gas, mit der die Referenzkammer befüllt wird, erst nach dem Bonden der Wafer, welche die Referenzkammer bilden, über eine Öffnung in einer separaten Beschichtungskammer eingeführt. In der Referenzkammer liegen MEMS-Bauteile eingebaut vor.

In einem weiteren Aspekt betrifft die Erfindung einen photoakustischen Gassensor umfassend eine solche Referenzkammer innerhalb derer ein MEMS-Sensor vorliegt.

### Hintergrund und Stand der Technik

Die photoakustische Spektroskopie (PAS) ist ein physikalisches Untersuchungsverfahren, welches auf dem photoakustischen Effekt basiert und vielseitige Einsatzgebiete aufweist.

Ein Einsatzgebiet der PAS ist die Detektion feinster Konzentrationen von Gasen. Hierbei wird intensitätsmodulierte Infrarotstrahlung mit Frequenzen im Absorptionsspektrum des in dem Gas zu detektierenden Moleküls eingesetzt. Ist dieses Molekül im Strahlengang vorhanden, findet eine modulierte Absorption statt, die zu Erwärmungs- und Abkühlungsprozessen führt, deren Zeitskalen die Modulationsfrequenz der Strahlung widerspiegeln. Die Erwärmungs- und Abkühlungsprozesse führen zu Expansionen und Kontraktion des Gases, wodurch Schallwellen mit der Modulationsfrequenz verursacht werden. Diese lassen dann sich durch Schalldetektoren, wie beispielsweise Mikrofone oder Flusssensoren, messen.

Beispielhaft ist die Detektion von CO₂, welche in der Forschung und der Klimatechnik eine Rolle spielt. Relevant sind aber auch Anwendungen, wo nicht nur giftige, sondern auch explosive oder korrosive Gase, wie z. B. Ammoniak NH₃, detektiert werden müssen.

Insbesondere für Ammoniak (NH₃) gibt es bereits zahlreiche Anwendungen in der Industrie und der Natur.

Beispielsweise wird Ammoniak als Kältemittel in Kühlhäusern, Brauereien und Schlachthöfen verwendet. Auch der Einsatz in Großkälteanlagen ist möglich. Mitte des 20. Jahrhunderts wurde Ammoniak vielfach durch Fluorkohlenwasserstoffe (FCKW) ersetzt, die wiederrum heutzutage verboten sind. Dennoch hat Ammoniak seine wichtige Rolle in der Industrie-Kältetechnik wegen seiner guten thermodynamischen Eigenschaften stets behaupten können.

Trotz der Tatsache, dass Ammoniak für die Verwendung in Kälteprozessen oftmals synthetisch hergestellt wird, wird es als natürliches Kältemittel bezeichnet. NH₃ entsteht zumeist beim Abbau organischer, stickstoffhaltiger Materialien. Heutzutage kommt es als Kältemittel in großen Kälteanlagen für Kühlhäuser und bei der Klimatisierung von Flughäfen, Bürogebäuden, Produktionshallen oder Sportanlagen zum Einsatz.

Ammoniak wirkt jedoch korrosiv, insbesondere gegenüber Kupferwerkstoffen. Rohrleitungen in einer Anlage mit Ammoniak als Kältemittel müssen deshalb in Stahl ausgeführt werden. Da Ammoniak zudem toxisch und bedingt brennbar ist, sind besondere Sicherheitsvorschriften für Bau, Betrieb und Wartung dieser Systeme erforderlich.

Ammoniakdämpfe können in konzentrierter Form zu Augen- und Atemreizungen führen, in erhöhten Konzentrationen können Schleimhäute und Lunge geschädigt werden und schlimmstenfalls zum Tode führen. Des Weiteren ist Ammoniak als wassergefährdend eingestuft. Es ist leicht wasserlöslich, sodass ein Eindringen in das Erdreich und eine einhergehende Grundwasserschädigung unbedingt zu vermeiden sind.

Darüber hinaus ist Ammoniak explosionsgefährlich (Zündtemperatur bei ca. 630°C).

Aus den obigen Gründen ist es wichtig, einen möglichen Austritt von Ammoniak frühzeitig zu erkennen.

Aufgrund der hohen Sensitivität bietet PAS hierzu eine ausgezeichnete Möglichkeit, um Ammoniakkonzentrationen kontinuierlich zu überwachen. Aus dem Stand der Technik sind dazu einige Vorrichtungen bekannt.

In Peng et al. 2016 wird ein Sensor offenbart, der Ammoniak in Umgebungen mit hoher Temperatur detektieren kann. Dabei kommt ein Quantenkaskadenlaser zum Einsatz, der eine zylindrische Messkammer mit einer Länge von ca. 1,8 m bestrahlt. Des Weiteren wird die Messkammer selbst erhitzt und darin ein Fluss erzeugt, indem Luft aus der Umgebung zugeführt wird. Zusätzlich werden weitere Verbindungen wie CH₄ (Methan) und 1% NH₃/Ar (Ammoniak/Argon) eingeführt, um den Fluss innerhalb der Kammer zu kontrollieren. Am Ende des Resonators befindet sich ein Detektor, der die Signalstärke des Quantenkaskadenlasers misst. Befindet sich ein höherer Anteil an Ammoniak in der Luft, welches in die Messkammer eingeführt wird, absorbiert dies die Strahlen des Quantenkaskadenlasers. Damit wird auch ein schwächeres Signal am Detektor registriert. Mit einer Messkammer von ca. 1,8 m Länge ist Vorrichtung für einen industriellen Einsatz ausgelegt und kann nicht flexibel eingesetzt werden. Darüber hinaus werden weitere Bestandteile hinzugefügt, wie z. B. Thermocouples (Thermoelemente), die die Temperaturverteilung messen, mit BaF₂ (Bariumfluorid) beschichtete Fenster, die sich an den Enden des Resonators befinden oder eine Hitzeummantelung des Resonators. Dies macht den Bau der Vorrichtung aufwendig und verkompliziert die Konstruktion.

In Schilt et al. 2004 bestrahlt ein CO₂-Laser (Kohlenstoffdioxidlaser) die photoakustische Messzelle. Diese umfasst einen zylindrischen Resonator und zwei Puffervolumina, wobei die beiden Puffervolumina als akustische Filter wirken. Am Ende des Resonators befindet sich ein Mikrofon. Weiterhin gibt es einen Halbleiterdetektor, der die Intensität der Laserstrahlen misst. Das Messprinzip ist dasselbe wie in Peng et al. 2016. Befinden sich im Strahlengang des C0₂-Lasers Anteile bzw. Moleküle von Ammoniak, wird ein Teil der Laserstrahlung absorbiert. Befindet sich kein Ammoniak im Resonator, ist das gemessene Drucksignal maximal. Ein Nachteil ergibt sich aus den Öffnungen, die sich an den beiden Puffervolumina befinden. Dadurch können prinzipielle weitere Gase in den Resonator hinein diffundieren, sodass das Messignal verfälscht werden könnte.

In Bonilla-Manrique et al. 2019 wird eine resonante Gaszelle beschrieben, die ebenfalls zwei Puffer und einen zylindrischen Resonator umfasst, wobei der zylindrische Resonator die beiden Puffer miteinander verbindet. Der Resonator weist eine Länge von 88 mm auf, die beiden Puffer eine Länge von jeweils 44 mm, sodass insgesamt die Vorrichtung eine Dimension von 176 mm besitzt. Am Resonator wird ein Mikrofon und ein dünnes Diaphragma platziert, die als akustische Detektoren wirken. Diese werden mittig am Resonator angebracht, wobei das Mikrofon durch den Resonator hineingebracht wird und das Diaphragma auf der gegenüberliegenden Seite von außen befestigt wird. Durch den photoakustischen Effekt wird auch das Diaphragma in Schwingungen versetzt. Im Versuchsaufbau wird sowohl der Gaseinlass, welches durch eines der beiden Puffer veräußert wird, als auch das Diaphragma mit Laserstrahlen bestrahlt. Dabei ist die Messzelle bereits mit 5000 ppm NH₃ gefüllt. Auch die Vorrichtung von Bonilla-Manrique et al. 2019 weist mithin makroskopische Dimensionen auf. Zudem wird nicht garantiert, dass das Messignal unverfälscht bleibt durch den Eintritt weiterer Moleküle, wie z. B. von CO₂ (Kohlenstoffdioxid) und H₂O (Wasser), die die Laserstrahlen absorbieren könnten.

Im Lichte des Standes der Technik besteht mithin ein Interesse an alternativen Vorrichtungen und/oder Verfahren, um potentiell giftige, korrosive und/oder explosive Gase, welche durch Miniaturisierungen weitergehende Einsatzmöglichkeiten haben, zuverlässig in eine Kammer oder eine Messzelle hermetisch abriegeln.

In US 6,124,145 wird ein Verfahren offenbart, womit Gas, insbesondere CO₂, innerhalb zweier oder mehrerer Wafer befüllt werden kann. Dabei wird ein erster Wafer, in der eine Kavität eingebracht wird, in eine Bondkammer gebracht, die mit dem Gas befüllt ist, welches sich innerhalb der Wafer ebenfalls befinden soll. Daraufhin wird der zweite Wafer mit dem ersten Wafer innerhalb der Bondkammer gebondet, sodass eine Kammer oder Zelle bestehend aus zwei Wafern entsteht, in der sich Gas befindet. Allerdings ist dieses Verfahren nicht ohne weiteres für den Einschluss von korrosiven oder explosiven Gasen, wie Ammoniak, geeignet.

Zum einen werden zum Bonden hohe Temperaturen benötigt. Damit können Gase, die bei den entsprechenden Bondtemperaturen entzündlich oder sogar explosiv sind, wie z. B. Ammoniak, nicht in die Kammer eingeschlossen werden. Andernfalls würden sie die Wafer oder auch die Bondkammer an sich beschädigen und im schlimmsten Fall zerstören. Zudem ist es mit diesem Verfahren nicht ohne Weiteres möglich, Kammern aus Wafern zu bilden, die eine elektronische Schaltung oder MEMS-Bauteile, wie beispielweise Sensoren, aufweisen und diese dann mit korrosiven Gasen, wie z. B. Ammoniak, zu befüllen. Das liegt daran, dass durch die korrosive Eigenschaft von Ammoniak die entsprechende elektronische Schaltung oder das MEMS-Bauteil beschädigt werden würde. Hinzu kommt, dass der Bondprozess an sich eine gewisse Zeit benötigt und die Konditionen (Temperaturen etc.) eine Reaktivität der korrosiven Gase begünstigen.

Im Stand der Technik sind weitere Verfahren sowie Vorrichtungen bekannt, die das Ziel verfolgen, ein Gas in ein miniaturisiertes System zu überführen.

So wird in der US 2018/0339900 A1 ein Verfahren zur Herstellung eines MEMS-Bauteils, in der sich mindestens zwei Sensoren befinden, offenbart. Der erste Sensor ist bevorzugt ein Drehratensensor, während der zweite Sensor vorzugsweise ein Beschleunigungssensor ist. Die beiden Sensoren werden in einem Wafer-Stack, jedoch in getrennten Bereichen gebildet. Die US 2018/0339900 A1 hat sich zur Aufgabe gesetzt zu verhindern, dass Gase wie H₂ (Wasserstoff) oder leichte Edelgase, wie beispielsweise Helium und Neon, bei den auftretenden Temperaturen durch Oxidschichten und andere Schichten diffundieren können. Beispielsweise kann H₂ vom Beschleunigungssensor in den Drehratensensor hineindiffundieren. Um das Problem zu lösen, wird im Rahmen des Herstellungsverfahrens zunächst ein MEMS-Wafer und ein Kappenwafer bereitgestellt, MEMS-Strukturen im MEMS-Wafer für die beiden Sensoren gebildet und anschließend der MEMS-Wafer mit dem Kappenwafer hermetisch abgeschlossen. Nach dem Verschluss der beiden Wafer wird ein erstes Zugangsloch gebildet und daraufhin ein erster Druck in die Kavität des ersten Sensors überführt und schließlich das Zugangsloch verschlossen. Ein analoges Vorgehen wird für den zweiten Sensor angewendet. Hierdurch soll es ermöglicht werden, dass in den Kavitäten zwei unterschiedliche interne Drücke vorliegen. Insbesondere ist es zudem vorgesehen, dass nach dem Bonden H₂ aus der Kavität des zweiten Sensors (Beschleunigungssensor) entfernt wird, um beispielsweise Sauerstoff, Ozon und/oder ein definiertes Plasma einzuführen. Die Bildung der Zugangslöcher erfolgt durch einen Laser. Auch das Verschließen der Zugangslöcher wird mithilfe eines Lasers vorgenommen.

Die US 2014/0038364 A1 offenbart ein Verfahren zur Einkapselung einer mikroelektronischen Vorrichtung. Die mikroelektronische Vorrichtung befindet sich auf einem ersten Substrat und wird in einer Bondkammer mit einem zweiten Substrat gebondet. Das zweite Substrat weist eine Kavität auf, sodass nach dem Bonden die mikroelektronische Vorrichtung sich innerhalb des Waferstacks befindet. Die Gase, die in die Kavität injiziert werden sollen, sind Edelgase. Das zweite Substrat weist einen Bereich auf, der permeabel hinsichtlich der Edelgase ist. Hierbei wird eine Schicht, die nicht-permeabel ist in Bezug auf das Edelgas, was in die Kavität eingeführt werden soll, auf das zweite Substrat beschichtet und anschließend Öffnungen darauf gebildet. Zum hermetischen Einschluss des Edelgases wird eine weitere Schicht aufgebracht, welche impermeabel ist gegenüber dem injizierten Helium. Eine Möglichkeit, Gase einzuführen, die reaktiver sind als die beschriebenen Edelgase, wird nicht offenbart.

US 2020/0057031 A1 offenbart ein Detektormodul für einen photoakustischen Gassensor. Das Detektormodul ist derart aufgebaut, dass ein erstes Substrat und ein zweites Substrat miteinander gebondet werden sowie eine Aussparung luftdicht mit einem Referenzgas ausgefüllt werden kann. Das Referenzgas kann in die Aussparung in einer Referenzgasatmosphäre während des Bondens eingeführt werden oder auch nach dem Bonden, indem ein Durchgangsloch im ersten oder zweiten Substrat gebildet wird, welches anschließend verschlossen wird. Das Referenzgas ist ausgewählt aus einer Gruppe umfassend CO₂, NOx, H₂O, O₂, N₂, CH₄ oder Alkohol. Eine Befüllung der Aussparung durch ein Gas innerhalb einer Beschichtungskammer wird nicht beschrieben.

Auch in der US 2021/0055207 A1 wird eine Detektorzelle für einen photoakustischen Gassensor offenbart. Dabei wird eine Gasatmosphäre eines einzuschließenden Gases hergestellt und kann während des Bondens in eine Kavität eingeschlossen werden.

US 2019/0353157 A1 offenbart eine Miniatur-Transportvorrichtung, die als Fluidsteuerung und/oder für die Durchführung einer Druckbeaufschlagung eingesetzt werden kann. Die Miniaturtransportvorrichtung und eine Miniatur-Ventilvorrichtung können zusammengebaut werden, woraufhin ein Gas durch einen Einlass eingeleitet werden kann. Durch einen piezoelektrischen Aktuator kann das Gas durch eine Vielzahl von Druckkammern strömen und kontinuierlich in eine Transportrichtung fließen. Das Gas kann ausgelassen werden, indem ein Benutzer die Menge das Gases selbst bestimmt oder wenn der Umgebungsdruck steigt.

US 2007/0295456 A1 beschreibt ein Material zum Bonden von Wafern. Das Bondmaterial zeichnet sich dadurch aus, dass es neben einer isolierenden Klebefähigkeit auch elektrisch leitende Partikel enthält. Des Weiteren wird dargelegt, dass in einer Bondkammer Luft gegen ein zu verkapselndes Gas ausgetauscht werden kann, insbesondere für den Betrieb einer MEMS-Vorrichtung. Die darin offenbarten Gase sind nicht explosiv, sondern reaktionsträge.

US 2003/0183916 A1 offenbart ein Verfahren zur Verpackung einer MEMS-Vorrichtung. In einer Ausführungsform kann ein Versiegelungsprozess in einer kontrollierten Umgebung durchgeführt werden, sodass die Kavität das gewünschte Umgebungsgas mit einem gewünschten Druck enthält. Hierzu wird beschrieben, dass die Öffnungen sich weit genug von der MEMS-Vorrichtung befinden, um diese nicht zu beschädigen. Ein Abdeck- bzw. Verschlusskomponente (patch) wird ebenso offenbart, um die Öffnungen zu verschließen.

Die US 2020/0198964 A1 behandelt ein Verkapselungsverfahren zum Anbringen einer MEMS-Vorrichtung innerhalb eines Waferstacks. Hierbei können die Öffnungen durch eine Verschlussschicht *(hole* seal *layer)* verschlossen werden können, wobei dies durch Beschichtung selbst ermöglicht werden soll.

Ein sicheres, zuverlässiges Herstellungsverfahren um korrosive und/oder explosive Gase in eine MEMS Zelle einzuführen und hermetisch abzuriegeln, ohne dass MEMS-Bauteile oder elektronische Schaltungen innerhalb der MEMS Zelle beschädigt werden können, ist bisher unbekannt. Insbesondere geht eine zuverlässige und sichere Einfuhr von korrosiven und/oder explosiven Gasen während der Herstellung von photoakustischen Gassensoren aus dem Stand der Technik nicht hervor. Mithin liegt ein Bedarf vor, die Einfuhr von Gasen in MEMS-Zellen effizienter und für Nutzer sicherer zu gestalten.

### Aufgabe der Erfindung

Aufgabe der Erfindung ist es, eine Vorrichtung sowie ein Verfahren zu deren Herstellung bereitzustellen, welche die Nachteile des Standes der Technik beseitigen. Insbesondere ist eine Aufgabe der Erfindung, eine PAS (photoakustische Spektroskopie) von korrosiven und/oder explosiven Gasen mittels einer zuverlässigen und sicher herzustellenden Vorrichtung zu ermöglichen, welche sich durch einen kompakten Aufbau und hermetischen Einschluss der korrosiven und/oder explosiven Gase auszeichnet. Das Herstellungsverfahren sollten zudem einfach, kostengünstig und massentauglich sein, um Anwendungen in den verschiedensten Bereichen zu ermöglichen.

### Zusammenfassung der Erfindung

Die Aufgabe der Erfindung wird durch die Merkmale der unabhängigen Ansprüche gelöst. Bevorzugte Ausführungsformen der Erfindung sind in den abhängigen Ansprüchen beschrieben.

In einem ersten Aspekt betrifft die Erfindung ein Herstellungsverfahren für einen photoakustischen Gassensor umfassend eine mit Gas gefüllten Referenzkammer, innerhalb der ein MEMS Bauteil und und optional eine elektronische Schaltung vorliegt, umfassend die nachfolgenden Schritte:
a) Bereitstellen eines ersten und eines zweiten Wafers, wobei mindestens der erste Wafer und/oder der zweite Wafer eine Kavität aufweist und wobei auf dem ersten und/oder zweiten Wafer das MEMS-Bauteil vorliegt, wobei das MEMS-Bauteil ein MEMS-Sensor ist,
b) Bonden des ersten Wafers mit dem zweiten Wafer innerhalb einer Bondkammer zur Bildung eines mit Referenzgas befüllbaren Volumens, wobei nach dem Bonden an einer Kontaktfläche der beiden Wafer eine Öffnung verbleibt, oder vor oder nach dem Bonden eine Öffnung in den ersten und/oder zweiten Wafer eingebracht wird,
c) Befluten eines Referenzgases in die Referenzkammer über die Öffnung innerhalb einer Beschichtungsanlage,
d) Verschließen der Öffnung der Referenzkammer innerhalb der Beschichtungsanlage,
e) Bereitstellen eines modulierbaren Emitters,
f) Anordnung der mit dem Referenzgas befüllten Referenzkammer und des modulierbaren Emitters, wobei die Referenzkammer im Strahlengang des Emitters vorliegt, sodass der Emitter mittels modulierbar emittierbarer Strahlung das Referenzgas in der Referenzkammer zur Ausbildung von Schalldruckwellen anregen kann, welche mit Hilfe des MEMS-Sensors detektierbar sind.

Das erfindungsgemäße Verfahren unterscheidet sich von US-Patent Nr. 6,124,145 dahingehend, dass das Gas, welches in die Referenzkammer eingeführt werden soll, sich nicht in der Bondkammer während des Bondprozesses befindet. Dieses aus dem Stand der Technik bekannte Verfahren schränkt die Wahl der Gase, die in die Referenzkammer eingeschlossen werden sollen, erheblich ein. Das liegt daran, dass während des Bondprozesses hohe Temperaturen auftreten. Je nach dem welches Bondverfahren angewendet wird, ist ein Temperaturbereich von 250°C bis hin zu 1000°C möglich. Gase, die bei diesen Temperaturen und den entsprechenden Druckverhältnissen entzündlich oder sogar explosiv sind, könnten mit dem Verfahren aus US-Patent Nr. 6,124,145 nicht eingeführt werden. Würde man dies tun, könnte die gesamte Versuchsanlage, insbesondere die Bondkammer, beschädigt oder sogar zerstört werden. Insbesondere kann durch das erfindungsgemäße Verfahren Ammoniak in die Referenzkammer eingeführt werden, dessen Zündtemperatur bei 630°C liegt.

Durch das erfindungsgemäße Verfahren können zudem auch Gase, die eine korrosive Wirkung haben, in die Referenzkammer eingeführt und eingeschlossen werden. Dies ist insbesondere entscheidend, falls in der Referenzkammer MEMS-Bauteile und/oder elektronische Schaltungen vorliegen. Mit dem aus US-Patent Nr. 6,124,145 bekannten Verfahren ist es nicht möglich korrosiv wirkende Gase in die Referenzkammer einzuschließen, ohne evtl. vorhandene MEMS-Bauteile und/oder elektronische Schaltungen zu beschädigen. Im Falle der Anwendung des aus US-Patent Nr. 6,124,145 bekannten Verfahrens wäre das MEMS-Bauteile und/oder die elektronische Schaltung von einer hohen Menge des korrosiven Gases umgeben, da das korrosive Gase innerhalb der gesamten Bondkammer beflutet wird.

In US-Patent Nr. 6,124,145 findet der Bondprozess insbesondere erst statt, nach dem die Bondkammer mit dem zu einzuschließenden Gas befüllt wird. Dadurch, dass der Bondprozess eine bestimmte Zeit benötigt, wäre das MEMS-Bauteil und/oder die elektronische Schaltung während dieser Zeit, die das Bonden beansprucht, vom korrosiven Gas umgeben, während gleichzeitig auch Sauerstoff, welcher sich in der Bondkammer befindet, die Reaktion fördern kann. Somit könnte das MEMS-Bauteil und/oder die elektronische Schaltung durch die hohe Menge des korrosiven Gases und durch die Verweildauer, in der es vom korrosiven Gas ausgesetzt wäre und die das Bonden benötigt, beschädigt werden.

Das erfindungsgemäße Verfahren unterscheidet sich auch gegenüber der US 2014/0038364 A1, insbesondere durch die Einfuhr des Referenzgases innerhalb einer Beschichtungskammer. Hingegen wird in der US 2014/0028264 A1 das Gas in der Bondkammer in die Kavität eingeführt wird. Dies schränkt die Auswahl der einzufüllenden Gase jedoch erheblich ein, da während des Bondens Temperaturen vorliegen, bei denen explosive und/oder reaktive Gase eine unerwünschte Reaktion, wie beispielsweise eine Explosion, ausführen können. In der US 2014/0028264 A1 werden aus dem Grund als Gase für die Einfuhr in die Kavität der MEMS-Zelle lediglich Edelgase eingesetzt, welche reaktionsträge sind. Erfindungsgemäß wird hingegen die Einfuhr des Referenzgases in einer Beschichtungskammer durchgeführt. Hierdurch können vorteilhaft auch Gase eingebracht werden, welche - anders als z. B. Helium - in einer Bondkammer bei den entsprechenden Bondtemperaturen entzündlich oder sogar explosiv sind, wie z. B. Ammoniak. Folglich erreicht das erfindungsgemäße Verfahren eine deutliche Verbesserung gegenüber dem Stand der Technik, da es ermöglicht wird, explosive und/oder korrosive Gase sicher in die Referenzkammer einzubringen und hermetisch zu verschließen.

Weiterhin kann vorteilhaft im erfindungsgemäßen Verfahren das Referenzgas in das Volumen der Referenzkammer direkt befüllt werden, in dem das Referenzgas in einer Beschichtungskammer beflutet wird, in welcher anschließend unmittelbar ein Verschluss des Referenzgases erfolgt. Mithin kann das Referenzgas bevorzugt durch Diffusion - als natürlich ablaufender physikalischer Prozess aufgrund der brownschen Molekularbewegung - in das Volumen der Referenzkammer eindringen. Hingegen findet in der US 2018/0339900 A1 ein Austauschprozess für die Befüllung eines Volumens statt, in dem sich einer der beiden darin beschriebenen Sensoren befindet. In der US 2018/033990 A1 wird dargelegt, dass beispielsweise H₂ aus der Kavität des zweiten Sensors entfernt und anschließend mit Sauerstoff, Ozon und/oder einem definierten Plasma befüllt wird, wodurch ein Austausch von Gasen stattfindet. Insbesondere können die in der US 2018/033990 A1 genannten Gase zumindest teilweise in die Oberfläche des MEMS-Elements eindringen, um dort mit dem Wasserstoff zu reagieren oder, wenn sie von der Oberfläche adsorbiert werden, die Entladungsenergie des im Festkörper gelösten Wasserstoffs reduzieren. Eine solche Bindungsreaktion oder Austausch wird im erfindungsgemäßen Verfahren vermieden.

Weiterhin erfolgt in der US 2018/033990 A1 keine Befüllung der Sensorkavität innerhalb einer Beschichtungsanlage erfolgt, sodass die Beschichtungsanlage zum Verschließen der Öffnungen einer Referenzkammer genutzt werden könnten. Stattdessen erfolgt ein Verschließen der Öffnung mittels eines Lasers.

Die Nachteile des Standes der Technik werden durch das erfindungsgemäße Verfahren umgangen bzw. beseitigt. Im erfindungsgemäßen Verfahren wird eine MEMS-Zelle mit einer Öffnung bereitgestellt, die dann anschließend mit dem einzuschließenden Gas befüllt wird. Dabei wird zunächst die Referenzkammer mithilfe zweier Wafer gebildet. Dies geschieht durch einen Bondprozess innerhalb einer Bondkammer. Eine Öffnung in das Volumen der Referenzkammer kann nach dem Bonden verbleiben. Die Öffnung kann aber auch vor oder nach dem Bonden in eines der beiden Wafer eingebracht werden. Nach dem Bondprozess, wodurch die MEMS-Zelle gebildet wird, wird diese in eine Beschichtungsanlage gebracht.

Anschließend wird die Beschichtungsanlage mit dem Gas, welches in MEMS-Zelle eingeschlossen werden soll, beflutet, sodass es über die Öffnung in das Volumen der MEMS-Zelle hinein diffundiert. In einem nächsten Schritt wird die Öffnung verschlossen und hermetisch abgeriegelt. Insbesondere kann durch das erfindungsgemäße Verfahren Ammoniak in MEMS-Zelle eingeschlossen werden, welches eine explosive und korrosive Wirkung aufweist. Aber auch andere Gase, die solche erschwerenden Eigenschaften mit sich bringen, können dadurch in die MEMS-Zelle eingeschlossen werden.

Vorteilhafterweise können mit dem erfindungsgemäßen Verfahren insbesondere korrosive und/oder explosive Gase in die MEMS-Zelle eingeschlossen werden, ohne darin vorhandene MEMS-Bauteile und/oder elektronische Schaltungen zu beschädigen oder zu zerstören. Das liegt daran, dass das Einführen des Gases in die MEMS-Zelle kontrollierter geschieht, da zum einen das Befluten dem Bondprozess nachgelagert in einer Beschichtungsanlage erfolgt und zum anderen die Öffnung mit geringerer Dimension ausgerichtet oder auch zusätzliche Verschließmechanismen versehen werden kann. Somit kann in Bezug auf den Zeitpunkt, die Konzentration und die Zeitdauer überaus kontrolliert das Gas in eine MEMS-Zelle eingeführt werden.

Zudem liegen innerhalb der Beschichtungsanlage, die mit dem einzuschließenden Gas beflutet wird, weniger reaktive Bedingungen vor, insbesondere eine geringere Temperatur als innerhalb der Bondkammer.

Im Sinne der Erfindung bezeichnet eine MEMS-Zelle bevorzugt eine Vorrichtung, welche zwei oder mehr Wafer umfasst und innerhalb derer ein MEMS-Bauteil vorliegt. Dabei kann der Begriff der MEMS-Zelle als Oberbegriff aufgefasst werden. Eine MEMS-Zelle kann eine oder mehrere Öffnungen umfassen, die geschlossen werden können. Eine MEMS-Zelle kann auch als Referenzkammer eingesetzt werden. Der Begriff der MEMS-Zelle taucht häufig im Zusammenhang mit MEMS basierten Technologien auf und ist dem Fachmann geläufig.

Im Sinne der Erfindung bezeichnet die Referenzkammer einen Hohlraum, der durch zwei oder mehr Wafer gebildet wird und ein Volumen umfasst, das durch die zwei oder mehr Wafer gebildet wird. Mit anderen Worten bilden zwei oder mehr Wafer ein Volumen und die Gesamtheit der Wafer und dem daraus resultierenden Volumen wird bevorzugt durch die Referenzkammer umfasst. Die Referenzkammer weist eine oder mehrere Öffnungen auf, welche zur Befüllung des Volumens der Referenzkammer vorliegen. Um das Gas innerhalb der Referenzkammer zu behalten bzw. einzuschließen, ist die Öffnung wiederverschließbar eingerichtet. Vorteilhafterweise ist dadurch kein Gasaustauch mit der Umgebung möglich. Das in der Referenzkammer einzubringende oder auch bereits eingebrachte Gas wird auch als Referenzgas bezeichnet.

Es befindet sich innerhalb der Referenzkammer ein MEMS-Bauteil und/oder eine elektronische Schaltung. Dabei bezeichnet im Sinne der Erfindung ein MEMS-Bauteil ein Bauteil oder eine Komponente, welches auf MEMS-Technologie beruht. MEMS steht für den englischen Ausdruck *microelectromechanical system,* also ein Mikrosystem, wodurch eine kompakte (Mikrometerbereich) Bauweise bei gleichzeitig hervorragender Funktionalität mit immer geringeren Herstellungskosten erreicht wird. Ein MEMS-Bauteil kann beispielsweise ein MEMS-Sensor oder auch ein MEMS-Aktuator sein. Im Stand der Technik sind viele MEMS-Bauteile bekannt. Vorteilhafterweise können durch das erfindungsgemäße Verfahren verschiedenste MEMS-Bauteile in eine Referenzkammer eingebracht und mit korrosiven und/oder explosiven Gasen befüllt werden, ohne diese zu beschädigen.

Im Sinne der Erfindung bezeichnet eine elektronische Schaltung ein Zusammenschluss von elektrischen oder elektromechanischen Einzelelementen zu einer funktionsgerechten Anordnung. Vorzugsweise erlaubt die elektronische Schaltung Daten bzw. elektrische Signale zu senden, zu empfangen und/oder zu verarbeiten.

Die MEMS-Bauteile werden oftmals auf einem Substrat gemeinsam mit einer elektronischen Schaltung zur Steuerung und/oder Auswertung angeordnet und stehen mit dieser über elektrische Verbindungen, welche beispielsweise durch Drahtbonds und/oder im Substrat angelegte Leiterbahnen, in Kontakt. Das Substrat fungiert insbesondere als Träger und kann zudem auch elektrische Funktionen realisieren, z. B. elektrische Verbindungen für die einzelnen Komponenten bereitstellen.

Bevorzugte elektronische Schaltungen umfassen ohne Beschränkung eine integrierte Schaltung (IC), ein Anwendungsspezifische integrierte Schaltungen (ASIC), eine programmierbare logische Schaltung (PLD), ein Field Programmable Gate Array (FPGA), einen Mikroprozessor, einen Mikrocomputer, eine speicherprogrammierbare Steuerung und/oder eine sonstige elektronische, bevorzugt programmierbare, Schaltung.

Zunächst werden zwei Wafer bereitgestellt, wobei mindestens der erste Wafer und/oder der zweite Wafer eine Kavität aufweist und wobei auf dem ersten und/oder dem zweiten Wafer ein MEMS-Bauteil und oder eine elektronische Schaltung vorliegt.

Im Sinne der Erfindung bezeichnet eine Kavität vorzugsweise eine Einkerbung oder Vertiefung in einem Wafer. Vorteilhafterweise kann durch das Vorhandensein einer oder mehrerer Kavitäten am ersten und/oder zweiten Wafer durch das Bonden der beiden Wafer ein geeignetes Volumen innerhalb der Referenzkammer resultieren. Bevorzugt werden durch die Kavitäten der ersten und/oder des zweiten Wafers nach dem Bonden beider Wafer die Referenzkammer gebildet.

Ein Wafer kann beispielsweise eine kreisrunde oder quadratische Scheibe mit einer Dicke im Millimeter oder Submillimeter-Bereich bezeichnen. Wafer werden typischerweise aus ein- oder polykristallinen (Halbleiter-)Rohlingen, sogenannten Ingots, hergestellt und dienen in der Regel als Substrat für z. B. Beschichtungen oder Bauteile, insbesondere MEMS-Bauteile und/oder elektronische Schaltungen. Die Verwendung des Begriffs Substrat für den Wafer ist im Stand der Technik auch bekannt, wobei das Substrat vorzugsweise das zu behandelnde Material bezeichnet. Im Sinne der Erfindung können die Begriffe Wafer und Substrat synonym verwandt werden.

In einer bevorzugten Ausführungsform umfassen die beiden Wafer Materialien ausgewählt aus der Gruppe bestehend aus monokristallinem Silizium, Polysilizium, Siliziumdioxid, Siliziumcarbid, Siliziumgermanium, Siliziumnitrid, Nitrid, Germanium, Kohlen, Galliumarsenid, Galliumnitrid, Indiumphosphid und/oder Glas.

Diese Materialien sind in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders geeignet, um in bestimmten Bereichen die gewünschten elektrischen, thermischen und/oder optischen Eigenschaften zu erzielen. Die vorgenannten Materialien bieten vielfältige Vorteile aufgrund der Verwendbarkeit standardisierter Herstellungstechniken, welche für die Integration von weiteren Komponenten, wie z. B. elektronischen Schaltungen ebenfalls besonders geeignet sind.

Bevorzugt ist das MEMS-Bauteil und/oder die elektronische Schaltung innerhalb der Kavität eines der beiden Wafer vorzufinden.

Gemäß der Erfindung werden die beiden Wafer durch Bonden zu einer Referenzkammer gebildet. Gemäß der Erfindung findet das Bonden innerhalb einer Bondkammer statt. Im Sinne der Erfindung bezeichnet eine Bondkammer eine Vorrichtung, in der Wafer platziert werden, um sie miteinander zu bonden.

Das Bonden von Wafern beschreibt einen Verfahrensschritt in der Halbleiter- und Mikrosystemtechnik, bei dem zwei Wafer oder Scheiben, z. B aus Silizium, Quarz, Glas und/oder den vorgenannten bevorzugten Substratmaterialien, miteinander verbunden werden.

Beim Bonden können vorzugsweise verschiedene Verfahren zum Einsatz kommen. Bevorzugt werden diese auch als Bondprozesse oder Bondverfahren im Sinne der Erfindung bezeichnet. Bevorzugte Bondprozesse umfassen direktes Bonden, anodisches Bonden, Bondverfahren mit Zwischenschichten, Glas-Frit-Bonden, adhäsives Bonden und/oder selektives Bonden.

Beim direkten Bonden, insbesondere von Silizium-Wafern, werden bevorzugt hydrophile und hydrophobe Oberflächen der Wafer unter hohen Temperaturen in Kontakt gebracht. Vorzugsweise wird dabei der eine Wafer mittig gegen den anderen gepresst, wobei vorteilhafterweise ein erster Kontaktpunkt entsteht. Diese mechanische Verbindung im Kontaktbereich beruht dabei vorzugsweise auf Wasserstoffbrücken und/oder Van-der-Waals-Wechselwirkungen. Der somit verbundene Kontaktbereich wird dabei vorzugsweise auf die übrige Waferfläche(n) ausgedehnt, indem anfangs vorhanden Abstandhalter zwischen diesen Flächen sukzessive entfernt werden. Dabei betragen die Prozesstemperaturen vorzugsweise zwischen 1000 °C und 1200 °C und es wird ein Druck auf die Wafer von beispielsweise der Größenordnung 10 Megapascal (MPa) bis 25 MPa ausgeübt. Das Direkt-Bonden kann vorzugsweise für die Verbindung zweier Siliziumwafer und/oder Siliziumdioxidwafer verwendet werden.

Beim anodischen Bonden findet insbesondere ein Glas mit erhöhter Na+-Ionenkonzentration (bevorzugt positiv geladenen Natriumionen) Verwendung, welches bevorzugt mit einem Siliziumwafer in Kontakt gebracht wird. Dabei wird eine elektrische Spannung angelegt, welche insbesondere konfiguriert ist, eine negative Polung am Glas zu erzeugen. Somit wird bevorzugt und insbesondere mithilfe einer erhöhten Prozesstemperatur erreicht, dass die Natriumionen (Na⁺) zur Elektrode diffundieren, wodurch sich bevorzugt eine Raumladungszone an der Grenzfläche ausbildet, welches eine Erhöhung des elektrischen Feldes bewirkt und Si-O-Si-Bindungen erzeugt. Diese Bindungen weiten sich bevorzugt sukzessive auf die gesamte Verbindungsfläche zwischen Glas und Silizium aus. Somit können insbesondere Glas und Siliziumwafer miteinander verbunden werden. Bei entsprechender Anpassung des Prozesses ist ebenso ein Bonden zweier Siliziumlagen und/oder einer Silizium-Metall Lage mit einem Glas möglich. Das anodische Bonden kann vorzugsweise bei Temperaturen von etwa 400 °C stattfinden, es kann ebenso bevorzugt bei "Niedrigtemperatur" bei etwa 180 °C stattfinden, wobei die zu bondenden Materialien vorzugsweise geschont werden. Bevorzugt können auch verschiedene der vorgenannten Materialien gebondet werden.

Bevorzugt können auch Bond-Verfahren mit sogenannten Zwischenschichten zwischen den zu bondenden Wafern zum Einsatz kommen, wie bspw. das sogenannte Eutektische Bonden, welches vorzugsweise auf einer Verbindung durch eine eutektische Legierung als Zwischenschicht, z. B. Si-Au (Silizium-Gold) oder Ge-Al (Germanium-Aluminium), basiert. Eine eutektische Legierung ist vorzugsweise eine Legierung, deren Bestandteile in einem solchen Verhältnis zueinander gemischt sind, dass bei einer bestimmten Temperatur die ganze Legierung flüssig bzw. fest wird. Eutektisches Bonden kann z. B. zum Verbinden zweier Siliziumwafer verwendet werden. Bevorzugt können jedoch auch andere der vorgenannten Materialien verbunden werden.

Auch das Glas-Frit-Bonden beruht bevorzugt auf der Verwendung einer Zwischenschicht zwischen den zu verbindenden Wafern, wobei die Verbindungsbildung insbesondere durch Aufschmelzen von Glasloten/Glasfritten. Glaslot umfasst bevorzugt ein Glas, welches eine niedrige Erweichungstemperatur aufweist, bspw. ca. 400 °C. Glasfrit umfasst bevorzugt oberflächlich geschmolzenes Glaspulver, dessen Glaskörner bevorzugt zumindest teilweise zusammenbacken bzw. -sintern. Diese Art des Bondens kann bevorzugt Silizium- und/oder Siliziumdioxidwafer miteinander verbinden, bevorzugt jedoch auch andere vorgenannte Materialien.

Das adhäsive Bonden beschreibt bevorzugt eine Verbindungsbildung durch eine Zwischenschicht umfassend Klebstoff. Durch adhäsives Bonden können vorzugsweise verschiedene der vorgenannten Materialien miteinander gebondet werden.

Bevorzugt kann durch Fotolithographie, Ätzen und/oder Lift-off-Verfahren ein selektives Bonden vorgenommen werden.

Durch Bonden der beiden Wafer, welche bevorzugt vorbearbeitet sind, um Kavitäten aufzuweisen, kann die Referenzkammer einfach hergestellt werden.

Das Bonden von Strukturen aus vorbearbeiteten Wafern erlaubt die einfache Herstellung komplexer Strukturen, welche nur mit großem Aufwand aus einem einzelnen Wafer hergestellt werden könnten. Dadurch kann die Referenzkammer hergestellt werden, ohne dass das Rohmaterial der Wafer aufwendig aus dem Inneren herausgearbeitet werden muss, um das Volumen innerhalb der Referenzkammer erzeugen.

In einer bevorzugten Ausführungsform weisen die Wafer Kontaktflächen auf, die beim Bonden der beiden Wafer zum Einsatz kommen. Kontaktflächen umfassen bevorzugt Bereiche des Wafers, die mit einem Material versehen sind bzw. beschichtet werden, welches zum Bonden benötigt werden. Die Materialien an den Kontaktflächen der beiden Wafer werden bevorzugt miteinander verbunden bzw. gebondet, um die Referenzkammer zu erzeugen. Ein solches Material kann im erfindungsgemäßen Kontext auch als Bondmaterial bezeichnet werden.

In einer bevorzugten Ausführungsform werden beiden Wafer derart gebondet, dass nach dem Bonden an einer Kontaktfläche der beiden Wafer eine Öffnung verbleibt. Die Öffnung resultiert bevorzugt daraus, dass an der entsprechenden Kontaktfläche kein Bonden stattfindet. Bevorzugt befindet sich die Öffnung in einem lateralen Bereich der Referenzkammer. Vorteilhafterweise kann durch die bevorzugte Öffnung im lateralen Bereich der Referenzkammer effizient ein Referenzgas darin eingeführt werden.

Im Sinne der Erfindung bezeichnet die Öffnung einen Einlass in das Volumen der Referenzkammer. Gemäß der Erfindung kann durch bzw. über die Öffnung das Referenzgas in das Volumen der Referenzkammer eingebracht werden und bevorzugt darin hermetisch abgeriegelt werden. Insbesondere kann das einzuführende Referenzgas direkt in Volumen der Referenzkammer durch die Öffnung hinein diffundieren. Die Diffusion ist bekannt als passive Bewegung von Teilchen des einzuführendes Referenzgases entlang eines Konzentrationsgefälles, der hierbei zu Beginn der Beflutung des Referenzgases in die Beschichtungskammer zwischen der Beschichtungskammer und dem Volumen der Referenzkammer vorliegt. Die Diffusion führt zu einem Ausgleich der Konzentrationen, welche auf die brownsche Molekularbewegung basiert. Da die Diffusion ein passiver Transportvorgang ist, wird vorteilhaft keine zusätzlich Energie benötigt. Insbesondere wird keine chemische Reaktion oder ein Austausch - im Gegensatz zur US 2018/0339900 A1 - benötigt, um das Gas in die Referenzkammer einzubringen. Mithin wird vorteilhafterweise eine besonders prozesseffiziente Einfuhr des Referenzgases in die Referenzkammer innerhalb einer Beschichtungsanlage ermöglicht.

In einer Ausführungsform befindet sich bereits vor dem Bonden eine Öffnung. Bevorzugt geschieht dies über ein Ätzprozess ausgehend von einer Außenseite des ersten oder des zweiten Wafers. Dadurch können alle Kontaktflächen zum Bonden genutzt werden, sodass die Öffnung am ersten oder zweiten Wafer verbleibt, welche vor dem Bondprozess gestaltet wurde und in das Volumen der Referenzkammer führt.

In einer weiteren bevorzugten Ausführungsform wird die Öffnung nach dem Bonden der beiden Wafer ausgehend von der Außenseite des ersten oder des zweiten Wafers gebildet. Auch in dieser Ausführungsform könnten vorteilhafterweise alle Kontaktflächen zum Bonden genutzt werden. Bevorzugt resultiert die Öffnung nach dem Bonden über ein Ätzprozess.

Gemäß der Erfindung wird die Referenzkammer, welche nach dem Bondprozess resultiert, aus der Bondkammer entfernt und innerhalb einer Beschichtungsanlage platziert.

Im Sinne der Erfindung bezeichnet eine Beschichtungsanlage vorzugsweise eine Vorrichtung, die die Herstellung und Bearbeitung von dünnen Schichten unterschiedlicher Materialien durchführt. Im Sinne der Erfindung bezeichnet eine dünne Schicht oder Dünnschicht bevorzugt eine Schicht eines festen Stoffes im Mikro- oder Nanometerbereich.

Gemäß der Erfindung wird die Beschichtungsanlage dazu verwendet, die Referenzkammer mit dem Referenzgas zu befüllen. Im Sinne der Erfindung bezeichnet das Referenzgas ein Gas, welches in das Volumen der Referenzkammer eingeführt und bevorzugt darin hermetisch abgeschlossen bzw. eingeschlossen wird.

Gemäß der Erfindung wird dazu die Beschichtungsanlage zunächst mit dem Referenzgas beflutet. Über die Öffnung gelangt das Referenzgas in das Volumen der Referenzkammer. Vorteilhafterweise liegen innerhalb der Beschichtungsanlage nicht die Temperaturbereiche vor, welche innerhalb der Bondkammer zum Bonden zwingend benötigt werden. Daher kann das Referenzgas ein Gas sein, welches sonst bei den hohen Temperaturen entzündlich oder explosiv wäre, welche innerhalb der Bondkammer vorliegen, in das Volumen der Referenzkammer eingebracht werden. Dies erweitert die Möglichkeiten an Gasen, welche in die Referenzkammer eingebracht werden können.

Vorteilhafterweise kann die Referenzkammer insbesondere auch mit korrosiven Gasen beflutet werden. Das MEMS-Bauteil und/oder die elektronische Schaltung innerhalb der Referenzkammer wird kontrolliert über die Öffnung mit dem korrosiven Gas in Kontakt gebracht. Da der folgende Schritt des hermetischen Verschließens unmittelbar im Anschluss in der Beschichtungsanlage erfolgen kann, wird eine Beschädigung des MEMS-Bauteiles und/oder der elektronischen Schaltung durch das korrosive Gas vermieden.

Gemäß der Erfindung wird nach dem Verfahrensschritt des Einführens des Gases in die Referenzkammer diese innerhalb der Beschichtungsanlage verschlossen. Gemäß der Erfindung findet nach dem Vorgang des Verschließens kein Austausch mehr mit der Umgebung der Referenzkammer statt. Somit ist das eingeführte Referenzgas innerhalb der Kammer vorhanden und kann sie nicht mehr verlassen bzw. in die Umgebung gelangen.

Im Sinne der Erfindung bezeichnet die Umgebung bevorzugt die Gesamtheit dessen, was sich außerhalb der Referenzkammer befindet. Bevorzugt umfasst dies die Beschichtungsanlage und das darin eingeführte Referenzgas, welches im vorherigen Verfahrensschritt damit beflutet wurde.

Vorteilhafterweise kann nach dem Verschließen der Referenzkammer das Referenzgas aus der Referenzkammer nicht mehr entweichen oder Referenzgas aus der Umgebung in die Referenzkammer hineingelangen. Mittels des Verfahrens kann somit gewährleistet werden, dass präzise eine bestimmte Menge an Referenzgas innerhalb des Volumens der Referenzkammer vorhanden ist.

Bevorzugt erfolgt das Verschließen der Referenzkammer über ein Beschichtungsverfahren innerhalb der Beschichtungskammer, wobei insbesondere die Öffnung über ein Beschichtungsverfahren verschlossen wird. Bevorzugt kann zu diesem Zweck mindestens die Öffnung mit einer Dünnschicht beschichtet zu werden. Eine Beschichtung, die sich mindestens entlang der Öffnung, bevorzugt im Wesentlichen entlang der Öffnung, erstreckt, hat sich dahingehend als vorteilhaft erwiesen, dass ein besonders präziser Verschluss aufgebracht wird. Weiterhin wird Beschichtungsmaterial für den Verschluss der Öffnung eingespart, sodass durch eine effiziente Materialnutzung eine hohe Wirtschaftlichkeit gewährleistet werden kann.

Es kann aber bevorzugt sein, im Wesentlichen die gesamte Referenzkammer mit einer Dünnschicht zu beschichten, um einen hermetischen Verschluss zu gewährleisten. Vorteilhaft wird durch eine Beschichtung, die sich im Wesentlichen entlang der bzw. um die gesamten Referenzkammer erstreckt, ein besonders zuverlässiger hermetischer Verschluss bereitgestellt. So gewährleistet eine Beschichtung um die gesamte Referenzkammer einerseits einen besonders hermetischen Verschluss und schützt anderseits besonders robust gegenüber möglichen Beschädigung von außen. Dies ist insbesondere relevant für Anwendungen bei denen das Gas explosiv und/oder korrosiv ist und an welche mithin höchste Sicherheitsanforderungen zu stellen sind. Auch werden, durch die Minimierung des Risikos, dass das eingeführte Gas entweichen kann, besonders genaue und damit zuverlässige Messungen ermöglicht, beispielsweise im Rahmen der photoakustischen Spektroskopie.

Im Sinne der Erfindung bezeichnet ein hermetischer Verschluss bevorzugt einen dichten Verschluss, welcher einen Stoffaustausch mit der Umgebung der Referenzkammer verhindert. Um geringste Kontaminationen des Volumens der Referenzkammer zu verhindern, ist ein hermetischer Verschluss bevorzugt. Vorrichtungen wie die Referenzkammer werden durch einen hermetischen Verschluss vorzugsweise absolut dicht gegenüber einen Stoff- bzw. Materieaustausch.

Im Sinne der Erfindung bezeichnet eine Kontamination eine unerwünschte Menge an Stoffanteilen oder Gemischen, welche in das Volumen der Referenzkammer gelangen kann. Bevorzugt wird durch das Verschließen der Referenzkammer eine Kontamination verhindert.

In einer bevorzugten Ausführungsform umfasst das Referenzgas korrosive und/oder explosive Gase, bevorzugt Methan, Propan, Propylen, Silan, Chlorsilan, Aluminiumtriisopropanolat, Wasserstoff und/oder Sauerstoff, besonders bevorzugt Ammoniak.

Vorteilhafterweise können nicht nur giftige, sondern auch explosive und/oder korrosive Gase durch das erfindungsgemäße Verfahren in das Volumen der Referenzkammer eingebracht werden. Vorteilhafterweise werden somit die Möglichkeiten an Referenzgasen erweitert. Hierdurch eine erhebliche Verbesserung gegenüber dem Stand der Technik erzielt, da die Auswahl auf Gase nicht auf inerte Gase (z. B. Edelgase wie in der US 2014/0038364 A1) beschränkt oder festgelegt ist.

Im US-Patent Nr. 6,124,145 bekannten Verfahren wird das Gas innerhalb der Bondkammer eingeführt, welches innerhalb der MEMS-Zelle eingeschlossen werden soll. Allerdings tauchen bei verschiedenen Bondprozessen hohe Temperaturen auf. Daher können Gase, die bei den Temperaturen entzündlich oder explosiv sind, nicht mit dem bekannten Verfahren in die Referenzkammer eingeschlossen werden. Andernfalls könnte Gefahren, wie z. B. die Explosion der Bondkammer, resultieren. Dies wäre ebenfalls für den Nutzer von Nachteil, welcher bei einer evtl. auftretenden Explosion zu Schaden kommen könnte. Durch das erfindungsgemäße Verfahren können vorteilhafterweise auch entzündliche und/oder explosive Gase in die Referenzkammer eingeschlossen werden. Auch in der US 2014/0038364 A1 wird das Gas (ein Edelgas) in die Kavität innerhalb der Bondkammer eingeführt. In Abkehr zum Stand der Technik wird jedoch erfindungsgemäß bevorzugt das Gas innerhalb der Beschichtungskammer in die MEMS-Zelle eingeführt, insbesondere durch Befluten der Beschichtungskammer mit dem Referenzgas, beispielsweise durch eine passive Diffusion.

Zudem ist es für verschiedene Anwendungen erstrebenswert, MEMS-Bauteile und/oder elektronische Schaltungen innerhalb der Referenzkammer einzubauen und diese mit einem Referenzgas zu befüllen, z. B. für die PAS (photoakustische Spektroskopie). Mit dem aus US-Patent Nr. 6,124,145 bekannten Verfahren kann in diesem Fall allerdings kein korrosives Gas in die Referenzkammer eingeschlossen werden. Das kommt daher zustande, dass dabei die Bondkammer mit dem einzuschließenden Gas beflutet wird. Daher wäre das MEMS-Bauteil und/oder die elektronische Schaltung zunächst einer hohen Menge des korrosiven Gases ausgesetzt, was zu Beschädigungen dieser führen könnte. Auch die Zeit, in der das MEMS-Bauteil und/oder die elektronische Schaltung dem korrosiven Gas ausgesetzt wäre, spielt hierbei eine Rolle. Das Bonden an sich der Wafer beansprucht auch etwas Zeit. Bis der Bondvorgang abgeschlossen ist, wäre das MEMS-Bauteil und/oder die elektronische Schaltung dem korrosiven Gas. Während der Zeit des Bondprozesses könnte daher das korrosive Gas das MEMS-Bauteil und/oder die elektronische Schaltung beschädigen oder sogar zerstören.

Mit dem erfindungsgemäßen Verfahren werden die Nachteile des Standes der Technik umgangen bzw. beseitigt. Somit können vorteilhaft mit dem erfindungsgemäßen Verfahren explosive und/oder korrosive Gase in die Referenzkammer eingeführt und hermetisch abgeriegelt werden.

Im Sinne der Erfindung bezeichnet bevorzugt entzündlich oder entzündbar die Eigenschaft eines Stoffes oder eines Gemisches einen niedrigen Flammpunkt zu haben. Bevorzugt bezeichnet dabei der Flammpunkt eines Stoffes die niedrigste Temperatur, bei der sich über einem Stoff ein zündfähiges Gemisch bilden kann. Bevorzugt gelten Gase oder deren Gemische als entzündlich, die in Luft bei 20°C und einem Standarddruck von 101,3 kPa (kilopascal) einen Explosionsbereich haben.

Im Sinne der Erfindung bezeichnet ein explosives Gas ein Gas oder Gemisch, welches bei ausreichend energetischer Wirkung, z. B. durch eine hohe Temperatur, eine bestimmte chemische Reaktion durchläuft, bei der sich ein hoher Anteil an Wärmeenergie entfalten kann. Dabei kommt eine heftig expandierende Wirkung zu Trage, die erhebliche Zerstörungen anrichten kann. Bei unsachgemäßem Umgang mit explosiven Stoffen oder Gasen besteht Lebensgefahr.

Im Sinne der Erfindung bezeichnet ein korrosives Gas bevorzugt ein Gas, welches mit der Referenzkammer und/oder dessen Bestandteile, wie z. B. dem MEMS-Bauteil und/oder der elektronischen Schaltung, eine chemische Reaktion eingeht und eine messbare Veränderung dadurch verursacht. Dieser Vorgang wird im Sinne der Erfindung bevorzugt als Korrosion bezeichnet. Korrosion kann zu einer Beeinträchtigung der Funktion der Referenzkammer oder der Bestandteile der Referenzkammer führen.

Vorteilhafterweise können durch das erfindungsgemäße Verfahren bevorzugt explosive und/oder korrosive Referenzgase in die Referenzkammer eingeführt werden. Durch das erfindungsgemäße Verfahren kann aber auch jedes beliebig andere Referenzgas eingeführt werden.

In einer bevorzugten Ausführungsform wird zur Einstellung eines Partialdruckes des Referenzgases innerhalb der Referenzkammer zusätzlich ein inertes Gas, bevorzugt Stickstoff, über die Öffnung in die Referenzkammer eingeführt.

Als Partialdruck wird im Sinne der Erfindung der Teildruck einer einzelnen Komponente eines Gasgemisches bezeichnet. Der Partialdruck entspricht dem Druck, den die einzelne Gaskomponente bei alleinigem Vorhandensein im betreffenden Volumen ausüben würde. Der Gesamtdruck setzt sich additiv aus den Partialdrücken zusammen, d. h. die Summe aller Partialdrücke ist gleich dem Gesamtdruck.

Vorteilhafterweise kann sich über die Regulierung des Partialdruckes des Referenzgases insbesondere die Menge bzw. Konzentration an Referenzgas in der Referenzkammer präzise vorgegeben werden. Dies ist vorteilhaft für bestimmte Anwendungen der Referenzkammer, z. B. als Sensor für die PAS. In den Anwendungsfällen kann durch Einstellung der Konzentration bzw. Menge des Referenzgase die gewünschte Referenzkonzentration bzw. Sensitivität vorgegeben werden. Mithin kann vorteilhaft die Menge des eingeführten Gases gezielt und präzise optimiert werden.

Als inertes Gas oder Inertgas wird im Sinne der Erfindung bevorzugt ein reaktionsträges Gas bezeichnet. Das Gas beteiligt sich nicht oder nur wenig an chemischen Reaktionen. In Bezug auf PAS-Anwendungen sollten das Inertgas zudem eine unterschiedliche Absorptionscharakteristik im betreffenden Anregungsbereich aufweisen. Beispiele inerter Gase umfassen Gase wie z.B. Stickstoff oder Edelgase wie Helium, Neon, Argon, Krypton, Xenon oder gasförmige Molekülverbindungen wie z. B. Schwefelhexafluorid.

Die genannten Vorteile der Erfindung basieren darauf, dass eine Öffnung nach dem Bonden an einer Kontaktfläche der beiden Wafer verbleibt, oder vor oder nach dem Bonden eine Öffnung in den ersten und/oder zweiten Wafer eingebracht wird

In einer bevorzugten Ausführungsform weisen der erste und der zweite Wafer Kontaktflächen auf, die zum Bonden des ersten mit dem zweiten Wafer dienen, wobei zum Bilden der Öffnung ein Bereich an Kontaktflächen nicht gebondet wird.

Bevorzugt bildet sich dadurch eine Öffnung im lateralen Bereich der Referenzkammer. Dadurch ist vorteilhafterweise ein gutes Eindringen des Referenzgases in die Referenzkammer innerhalb der Beschichtungsanlage möglich.

Vorteilhafterweise sind mit dieser Ausführungsform keine weiteren Verfahrensschritte notwendig, um eine Öffnung in der Referenzkammer zu bilden. Die Öffnung wird bevorzugt bereits während des Bondprozesses hergestellt. Dadurch, dass keine weiteren Verfahrensschritte benötigt werden, kann auch auf weiteres Material und eine Strukturierung verzichtet werden. Die Herstellungskosten und - zeit verringern sich. Hierdurch wird vorteilhaft eine höhere Prozesseffizienz erreicht.

In einer bevorzugten Ausführungsform verbleibt eine Öffnung nach dem Bonden an einer Kontaktfläche der beiden Wafer, wobei die Öffnung einen Querschnitt von 1 µm² bis 1000 µm², bevorzugt 1 µm² bis 100 µm² und eine Länge von 1 µm bis 1000 µm, bevorzugt 10 µm bis 500 µm aufweist.

Vorteilhafterweise ergibt sich durch die Maße der Öffnung in dieser bevorzugten Ausführungsform eine diffusionshemmende Wirkung. Dabei bezeichnet die Diffusion im Sinne der Erfindung das Phänomen, dass ohne äußere Einwirkung ein Ausgleich von Konzentrationsunterschieden eintritt. Zu Beginn, wenn die Beschichtungsanlage mit dem Referenzgas beflutet wird, befindet sich kein bis wenig Gas innerhalb des Volumens der Referenzkammer. Mit der Zeit diffundiert das Referenzgas über die Öffnung in das Volumen der Referenzkammer. Dies ist ein passiver physikalischer Prozess aufgrund der brownschen Molekularbewegung. Der Prozess der Beflutung kann durch Einbringung des Referenzgases in die Beschichtungsanlage mit erhöhtem Druck und/oder Konzentration begünstigt werden.

Durch die bevorzugte Dimensionierung als im Wesentlichen längliche Öffnung ergibt sich eine im Wesentlichen eindimensionale Diffusionsdynamik, bei dem nach dem Diffundieren durch die Öffnung in das Volumen das Referenzgas dieses nicht oder nur über längere Zeitkonstanten verlässt.

Die diffusionshemmende Wirkung kann genutzt werden, um beispielsweise Zwischenzeiten in der Prozessierung zu überbrücken. Beispielsweise kann es bevorzugt sein, in der Beschichtungsanlage die Referenzkammer zunächst mit einem Referenzgas zu befluten, im Anschluss innerhalb der Kammer das Referenzgas gegen eine Prozessgas zu tauschen und eine Schließung der Öffnung mittels eines Beschichtungsprozesses vorzunehmen. Aufgrund der diffusionshemmenden Wirkung entweicht das Referenzgas während des Austausches der Gase oder der Durchführung des Beschichtungsprozesses nicht.

Durch entsprechende Dimensionierung der Öffnung kann vorteilhaft eingestellt werden, in welcher Zeitspanne das Referenzgas in die Referenzkammer hineindiffundieren kann und über welche Zeitspanne ein Herausdiffundieren sicher vermieden wird. Obengenannte bevorzugte Maße stellen in dieser Hinsicht einen guten Kompromiss dar.

In einer bevorzugten Ausführungsform wird vor oder nach dem Bonden des ersten Wafers mit dem zweiten Wafer die Öffnung ausgehend von einer Außenseite zu einer Innenseite des ersten Wafers oder des zweiten Wafers gebildet, bevorzugt mittels eines Ätzprozesses.

Vorteilhafterweise kann durch Einbringen der Öffnung vor oder nach dem die Position und/oder Dimensionierung der Öffnung präzise gewählt werden. Beispielsweise kann die Positionierung in Abhängigkeit eines MEMS-Bauteiles und/oder einer elektrischen Schaltung in der Referenzkammer erfolgen, um eine Beeinflussung zu vermeiden. Beispielsweise kann es bevorzugt sein, dass die Öffnung mittig der Außenseite des ersten oder des zweiten Wafers ausgehend von der Außenseite in die Innenseite der Referenzkammer strukturiert wird.

Im Sinne der Erfindung umfasst ein Ätzprozess bevorzugt Trockenätzen, nasschemisches Ätzen und/oder Plasmaätzen, insbesondere Reaktives Ionenätzen, Reaktives Ionentiefenätzen (Bosch-Prozess).

Ein Ätzprozess bezeichnet bevorzugt die Abtragung von Material einer Oberfläche. Die Abtragung kann sich in Form von Vertiefungen veräußern, die Kavitäten an Wafer hinterlassen.

Unter Trockenätzen fasst man in der Halbleitertechnologie und in der Mikrosystemtechnik eine Gruppe von abtragenden Mikrostrukturverfahren zusammen, die nicht auf nasschemischen Reaktionen (wie nasschemisches Ätzen, chemisch-mechanisches Polieren) basieren. Der Materialabtrag erfolgt dabei entweder durch beschleunigte Teilchen oder mithilfe plasmaaktivierter Gase. Es werden also je nach Verfahren chemische sowie physikalische Effekte ausgenutzt.

Trockenätz-Verfahren lassen sich in drei Gruppen einordnen. Zum einen die physikalischen Trockenätzverfahren, sie basieren auf dem Materialabtrag durch Beschuss mit Teilchen, zum anderen chemische Trockenätzverfahren, sie basieren auf einer chemischen Reaktion eines meist plasmaaktiverten Gases. Die dritte Gruppe, die physikalisch-chemischen Trockenätzverfahren, fasst Prozesse zusammen, die beide Wirkmechanismen nutzen, und ist so in der Lage, die Nachteile der ersten beiden Gruppen zu minimieren.

Beim nasschemischen Ätzen wird eine ätzresistente Maskierung durch einen chemischen Abtragungsprozess in den Wafer übertragen.

Plasmaätzen ist ein materialabtragendes, plasmaunterstütztes Trockenätz-Verfahren. Beim Plasmaätzen unterscheidet man zwischen einem Ätzabtrag aufgrund einer chemischen Reaktion und einem physikalischen Abtrag der Oberfläche aufgrund von Ionenbeschuss.

Beim chemischen Plasmaätzen erfolgt der Materialabtrag durch eine chemische Reaktion. Deshalb ist es im Allgemeinen isotrop und aufgrund des chemischen Charakters auch sehr materialselektiv. Beim physikalischen Plasmaätzen, auch plasmaunterstützten Ionenätzen genannt, handelt es sich um ein physikalisches Verfahren. Bei diesem Verfahren kann eine gewisse Vorzugsrichtung im Ätzangriff entstehen, daher weisen die Verfahren unter Umständen eine Anisotropie im Materialabtrag auf. Beim physikalischen Plasmaätzen werden im Plasma nicht reaktive Ionen erzeugt. Durch ein angelegtes elektrisches Feld werden diese Ionen auf eine Oberfläche beschleunigt und entfernen so Teile der Oberfläche. Dieses Verfahren wird typischerweise zum Entfernen des natürlichen Oxides auf Silizium Wafern verwendet.

Das reaktive Ionenätzen (englisch *reactive ion etching,* RIE) ist ein ionen unterstützter Reaktivätzprozess. RIE ist wegen der guten Kontrollierbarkeit des Ätzverhaltens ein Verfahren zur Herstellung von topografischen Strukturen für die Mikro- und Nanosystemtechnologie. Das Verfahren lässt durch chemisch-physikalischen Abtrag sowohl eine isotrope (richtungsunabhängig) als auch eine anisotrope Ätzung zu. Das Ätzen erfolgt durch aufgeladene Teilchen (Ionen), die in einem Gasplasma erzeugt wurden. Eine entsprechende Maskierung (z. B. durch Fotolithografie erzeugt) der Oberfläche gibt die Formgebung der Strukturen.

Reaktives Ionentiefenätzen (englisch *deep reactive ion etching,* DRIE) ist eine Weiterentwicklung des reaktiven Ionenätzens (RIE) und ein hoch anisotroper Trockenätzprozess für die Herstellung von Mikrostrukturen in Wafer mit einem Aspektverhältnis (Verhältnis von Tiefe zu Breite) von bis zu 50:1, wobei Strukturtiefen von einigen 100 Mikrometern erreicht werden können. Der DRIE-Prozess ist ein zweistufiger, alternierender Trockenätzprozess, bei dem sich Ätz- und Passivierungsschritte abwechseln. Ziel ist es, möglichst anisotrop zu ätzen, das heißt richtungsabhängig, senkrecht zur Wafer-Oberfläche. Auf diese Weise können beispielsweise sehr schmale Gräben geätzt werden.

Die vorgenannten Ätzprozesse sind dem Fachmann bekannt. In Abhängigkeit der gewünschten Öffnung und/oder bereitgestellten Wafer, können vorteilhafte Verfahren gewählt werden, um eine effiziente Durchführung zu gewährleisten.

In einer bevorzugten Ausführungsform liegt am Ende der Öffnung des ersten oder des zweiten Wafers ein Ventil vor, wobei sich das Ventil bevorzugt nach dem Bonden des ersten Wafers mit dem zweiten Wafer am Ende der Öffnung ausgehend von der Außenseite des ersten Wafers oder des zweiten Wafers im Volumen der Referenzkammer befindet. Das Ende der Öffnung bezeichnet bevorzugt den Übergang von der Öffnung im ersten oder zweiten Wafer zum (Referenz-)volumen der Referenzkammer.

Durch ein Ventil an der Position kann die Diffusion des Referenzgases, womit die Beschichtungskammer beflutet wird, in das Volumen der Referenzkammer geregelt werden.

Mit dem Anbringen eines Ventils wird vorteilhafterweise ein automatischer Verschluss des Referenzgases möglich. Insbesondere kann ein Entweichen von bereits in das Volumen diffundiertem Referenzgas verhindert werden, ohne dass hierzu die Dynamik des Beflutens eingeschränkt würde.

Anders als bei einer diffusionshemmenden Wirkung, beispielsweise durch eine längliche Öffnung mit einer im Wesentlichen eindimensionalen Diffusionsdynamik, kann mittels eines Ventils gezielter ein Diffundieren aus der Referenzkammer blockiert werden, während ein Diffundieren in die Referenzkammer ungehindert zügig erfolgen kann.

Mittels eines Ventils kann somit ein effizientes Befluten erfolgen, welches es beispielsweise erlaubt, innerhalb der Kammer das Referenzgas gegen eine Prozessgas zu tauschen und eine Schließung der Öffnung mittels eines Beschichtungsprozesses vorzunehmen. Aufgrund der Bereitstellung eines Ventils kann das Referenzgas auch in dieser Zeit nicht entweichen.

Zudem kann die Bereitstellung eines Ventils vorteilhaft eine präzisere Regulation der Menge und/oder Konzentration des in die Referenzkammer einzubringenden Referenzgases ermöglichen.

Ein Ventil bezeichnet bevorzugt ein Bauteil, welches zur Richtungssteuerung oder Absperrung eines Durchflusses von Fluiden dient. Bevorzugt kann ein Ventil durch beispielsweise einen biegsamen Verschluss - zum Beispiel auf Basis einer Dünnfilmstruktur - gebildet werden, welcher unidirektional ein Diffundieren des Referenzgases in die Reaktionskammer während des Beflutens erlaubt, während ein Diffundieren aus der Diffusionskammer nach dem Befluten verhindert wird.

Bevorzugt kann hierbei vor dem Bonden und vor dem Bilden der Öffnung des ersten oder des zweiten Wafers eine Materialschicht - bevorzugt zur Bildung eines biegsamen Verschlusses - auf der entgegengesetzten Seite eines Wafers aufgebracht werden, von welchem aus eine Öffnung eingebracht (z. B. geätzt) wird. Bevorzugt kann die Materialschicht im weiteren Prozess dazu dienen, als Ventil strukturiert zu werden. Hierbei kann zunächst die Öffnung des ersten oder des zweiten Wafers gebildet werden und im Anschluss die Materialschicht zu einem Ventil strukturiert werden. Auch eine umgedrehte Reihenfolge ist möglich.

In einer bevorzugten Ausführungsform wird die Materialschicht, welches das Ventil bilden soll, vor dem Bonden strukturiert. Hierbei gebildete Strukturen können Kontaktpads, Leiterbahnen, Ausrichtungen, Ecken, Kanten, Vertiefungen, Senken und/oder Löcher umfassen.

Bevorzugt kann die Materialschicht zunächst auf der gesamten Oberfläche einer Seite des Wafers aufgetragen werden. Das Strukturieren kann insbesondere die Materialschicht auf einen Bereich um die Öffnung einschränken, sodass der bestehende Bereich der Materialschicht am Ende der Öffnung als Ventil wirken kann.

Bevorzugt wird die Öffnung in dem Wafer auf der entgegengesetzten der zum Ventil strukturierten Materialschicht mittels eines Ätzprozesses gebildet. Der Fachmann kann zu diesem Zweck geeignete Ätzprozesse wählen, um zu gewährleisten, dass in dem Prozess das Ventil nicht beschädigt wird.

Im Anschluss erfolgt bevorzugt ein Bonden des ersten Wafers, umfassend eine Öffnung mit Ventil und dem zweiten Wafer. Das Bonden erfolgt derart, dass sich das Ventil am Ende der Öffnung und innerhalb des Volumens der Referenzkammer befindet, sodass sich die beschriebene Funktionsfähigkeit entfaltet.

In einer bevorzugten Ausführungsform wird nach dem Bonden des ersten Wafers mit dem zweiten Wafer die Referenzkammer in der Beschichtungsanlage mit dem Referenzgas beflutet, wobei das Gas über die Öffnung und über das Ventil in das Volumen der Referenzkammer gelangt.

In einer bevorzugten Ausführungsform umfasst das Ventil (bzw. die zu strukturierende Materialschicht) ein Weichmetall. Bevorzugt soll im Sinne der Erfindung Weichmetalle als Metalle definiert werden, welche eine geringere Härte als Eisen aufweisen (z.B. bei einer Härteprüfung nach Brinell gemäß DIN EN ISO 6506-1 bis 4). Bevorzugte Weichmetalle sind Nichteisenmetalle ausgewählt aus der Gruppe bestehend aus Blei, Gold, Indium, Kupfer, Platin, Silber, Zink, Zinn oder deren Verbindungen, besonders bevorzugt Aluminium oder dessen Verbindungen.

Vorteilhafterweise lässt sich ein Weichmetall zum einen mit einfachen Mitteln präzise strukturieren, sodass der Prozess zeit- und kostengünstig gestaltet werden kann. Zum anderen eignen sich Weichmetall aufgrund ihrer Biegsamkeit als Ventil für die erfindungsgemäße Verwendung.

Neben der Materialwahl spielt diesbezüglich weiterhin die Dimensionierung der Materialschicht eine Rolle.

Bevorzugt wird die Materialschicht zur Strukturierung des Ventils bzw. das Ventil als Dünnfilmstruktur ausgeführt. Dünnfilmstruktur meint bevorzugt eine Schichtdicke von weniger als 100 µm, bevorzugt weniger als 10 µm.

Insbesondere durch Verwendung einer Dünnfilmstruktur, bevorzugt umfassend Weichmetall, kann eine gute Biegsamkeit des Ventils gewährleistet werden, um den Diffusionsprozess entsprechend zu regulieren.

Das Referenzgas dringt über die Öffnung innerhalb ersten oder des zweiten Wafers bis zum Ventil ein und übt dort einen Druck gegen das Ventil aus. In Abhängigkeit der Biegsamkeit des Ventils, ist ab einem bestimmten Punkt der ausgeübte Druck groß genug, um das das Ventil in Richtung des Volumens der Referenzkammer zu öffnen und ein Passieren zu ermöglichen.

In einer bevorzugten Ausführungsform wird nach dem Befluten des Referenzgases in die Referenzkammer zum Verschließen der Öffnung das Lot geschmolzen.

Das Lot wird zu diesem Zweck bevorzugt in die Nähe der Öffnung der Referenzkammer angebracht, vorzugsweise vor dem Bonden.

Das Anbringen eines Lotes in der Mikrosystemtechnik ist ein bekanntes Verfahren und für den Fachmann mit keinen Schwierigkeiten verbunden.

Bevorzugt wird hierbei das Lot in die Nähe der Öffnung der Referenzkammer angebracht, bevor das Referenzgas in der Beschichtungsanlage beflutet wird und das Referenzgas über die Öffnung in das Volumen der Referenzkammer hineindiffundiert.

Vorteilhafterweise kann in dieser Ausführungsform vor dem Schmelzen des Lotes das Referenzgas besonders effizient in das Volumen der Referenzkammer hineindiffundieren. Da in dieser Ausführungsform weder eine diffusionslimitierende Wirkung einer länglichen Öffnung noch ein Ventil bereitgestellt werden muss, welches einen (wenn auch geringen) Restwiderstand ggü. der Diffusion aufweisen kann.

Bevorzugt wird durch das Schmelzen des Lotes die Öffnung der Referenzkammer verschlossen. Das Schmelzen des Lotes ist für den Fachmann ein bekannter Verfahrensschritt, wobei die Schmelztemperatur in Abhängigkeit des zu schmelzenden Materials gewählt wird.

Bevorzugt gelangt beim Schmelzen des Lotes ein Teil des Materials, woraus das Lot besteht, in die Öffnung hinein und verschließt deren Querschnitt. Das Lot bzw. geschmolzene Material kann die gesamte Öffnung oder nur einen Teil ausfüllen, solange der Querschnitt dicht verschlossen wird. Die Größe des Lots wird an die zu verschließende Öffnung angepasst. Hierbei kann es bevorzugt sein, dass das gesamte geschmolzene Material zur Schließung der Öffnung verwandt wird oder nur ein Teil davon.

Das Anbringen des Lotes in die Nähe der Öffnung, bezeichnet bevorzugt eine Positionierung in einer räumliche Nähe, welcher sicherstellt, dass das geschmolzene Lot auch in die Öffnung hineinfließen kann. In der Nähe kann beispielsweise eine Distanz von weniger als 100 µm, bevorzugt weniger als 10 µm meinen.

In einer bevorzugten Ausführungsform umfasst das Lot ein schmelzbares Material ausgewählt aus der Gruppe umfassend Blei, Zinn, Zink, Silber, Kupfer, deren Legierungen und/oder deren Verbindungen.

Bevorzugt wird beim Schmelzen das Lot ihrer Schmelztemperatur zugeführt. Dabei bezeichnet die Schmelztemperatur die Temperatur, bei der das Lot vom festen in den flüssigen Aggregatzustand überführt wird. Bevorzugt weist das Lot eine Schmelztemperatur auf, bei der das Referenzgas nicht entzündlich und/oder explosiv reagiert, sodass evtl. auftretende Funken nicht zu Gefahren führen würden.

Vorteilhafterweise haben die oben genannten bevorzugten Materialien für das Lot Schmelztemperaturen unterhalb der Temperatur, bei der die bevorzugten Referenzgase entzündlich und/oder explosiv reagieren.

In einer bevorzugten Ausführungsform erfolgt das Verschließen der Öffnung durch ein Beschichtungsverfahren innerhalb der Beschichtungsanlage, bevorzugt durch eine Sprühbeschichtung, Nebelbeschichtung und/oder Dampfbeschichtung.

Durch das Beschichtungsverfahren wird die Referenzkammer bevorzugt gut hermetisch abgeriegelt. Dies führt vorteilhafterweise dazu, dass das Referenzgas nicht mehr die Referenzkammer verlassen kann und ein permanentes Verschließen gewährleistet ist.

Im Falle des Ventils am Ende der Öffnung und im Falle des eingeschmolzenen Lotes ergibt sich bereits ein erstes Verschließen der Öffnung. Durch das zusätzliche Aufbringen einer Abdeckschicht, wird das Verschließen langzeitstabilisiert und eine hermetische Abriegelung der Referenzkammer über die Lebensdauer des Referenzkammer gesichert.

Verschiedene Beschichtungsverfahren können zum Auftragen einer Abdeckschicht genutzt werden.

Eine Sprühbeschichtung bezeichnet insbesondere ein flächiges Aufbringen einer Abdeckschicht, wobei die Abdeckschicht vor dem Sprühen vorzugsweise unter Druck gestellt wird (z. B. größer als der vorherrschende Umgebungsdruck), sodass feine Partikel/Aerosole der Abdeckschicht und/oder ein Schaum entstehen. Dadurch kann eine besonders feine Beschichtung erreicht werden, welche alle besprühten Bereiche bedeckt, auch wenn diese beispielsweise Flächen aufweisen, welche gegenüber der Sprührichtung in einem ungünstigen Winkel liegen. Auch zueinander abgewinkelte Flächen/Bereiche können so bevorzugt direkt bedeckt werden.

Bevorzugt wird hierfür eine flüssige Abdeckschicht unter gegenüber der Umgebung erhöhten Druckzerstäubt und flächig aufgebracht.

Die Sprühbeschichtung ist vorzugsweise eine Sprühbelackung. Die Sprühbeschichtung kann auch eine Gasphasenabscheidung sein.

Eine Nebelbeschichtung umfasst vorzugsweise eine Beschichtung durch feine Tröpfchen der Abdeckschicht, welcher in einer Atmosphäre (bevorzugt ein Gas) fein verteilt sind. Eine Dampfbeschichtung erfolgt vorzugsweise durch eine aufzutragende Abdeckschicht in Dampfform, bzw. gasförmig.

In einer bevorzugten Ausführungsform umfasst die Beschichtungsanlage eine physikalische Beschichtungsanlage oder chemische Beschichtungsanlage, bevorzugt plasmagestützte chemische Beschichtungsanlage, Niederdruck-chemische und/oder Epitaxie-Beschichtungsanlage.

Eine physikalische Beschichtungsanlage bezeichnet bevorzugt eine Beschichtungsanlage, die die Beschichtung durch die physikalische Gasphasenabscheidung durchführt. Die physikalische Gasphasenabscheidung (englisch *physical vapour deposition,* kurz *PVD*)*,* selten auch physikalische Dampfphasenabscheidung, bezeichnet eine Gruppe von vakuumbasierten Beschichtungsverfahren bzw. Dünnschichttechnologien. Anders als bei Verfahren der chemischen Gasphasenabscheidung wird mithilfe physikalischer Verfahren das Ausgangsmaterial in die Gasphase überführt. Das gasförmige Material wird anschließend zum zu beschichtenden Wafer geführt, wo es kondensiert und die Zielschicht bildet.

Lichtbogenverdampfen oder Arc-PVD (auch *arc evaporation,* von englisch *arc* ,Bogen ) ist ein Beschichtungsverfahren aus der Gruppe der physikalischen Gasphasenabscheidung. Bei diesem Verfahren brennt zwischen der Kammer, in der das Verfahren stattfindet, und dem auf negativem Potenzial liegenden Target ein Lichtbogen, der das später z. B. auf ein Werkstück (dem Wafer) aufzubringende Targetmaterial schmilzt und verdampft. Das Target wirkt als Kathode, die Kammerwand der Vakuumkammer oder eine definierte Elektrode als Anode. Dabei wird ein großer Teil (bis zu 90%) des verdampften Materials ionisiert. Der Materialdampf (Targetmaterial) breitet sich ähnlich wie beim thermischen Verdampfen radial vom Target aus. Da an dem Wafer zusätzlich ein negatives Potenzial gelegt wird, wird der ionisierte Materialdampf zusätzlich zum Substrat hin beschleunigt. An der Waferoberfläche kondensiert der Materialdampf.

Eine Epitaxie-Beschichtungsanlage bezeichnet bevorzugt eine Anlage, worin ein Epitaxie-Verfahren angewendet wird, bevorzugt die Molekularstrahlepitaxie. Die Molekularstrahlepitaxie (englisch *molecular beam epitaxy,* MBE) ist ein Verfahren der physikalischen Gasphasenabscheidung (PVD), um kristalline dünne Schichten (bzw. Schichtsysteme) herzustellen. Epitaxie bedeutet, dass die Kristallstruktur der aufwachsenden Schicht sich der des Substrates anpasst, solange die physikalischen Eigenschaften der beiden Substanzen nicht zu stark voneinander abweichen.

MBE setzt ein Ultrahochvakuum voraus, um Verunreinigungen durch Restgasatome zu vermeiden. Während des Wachstumsprozesses steigt der Druck aber bedingt durch die Effusion in den Hochvakuumbereich. Die Stoffe, aus denen die Schicht bestehen soll, werden in Evaporationstiegeln erhitzt und gelangen als gerichteter Molekularstrahl (ohne Stöße mit dem Hintergrundgas) zum Wafer. Dieses wird ebenfalls geheizt und erlaubt so ein geordnetes Anwachsen der Schicht.

Das Sputtern (von englisch *to sputter =* zerstäuben), auch Kathodenzerstäubung genannt, ist ein physikalischer Vorgang, bei dem Atome aus einem Festkörper (Target) durch Beschuss mit energiereichen Ionen (vorwiegend Edelgasionen) herausgelöst werden und in die Gasphase übergehen.

Eine chemische Beschichtungsanlage bezeichnet bevorzugt eine Beschichtungsanlage, die über die chemische Gasphasenabscheidung Beschichtungen durchführt. Bei der chemischen Gasphasenabscheidung (englisch *chemical vapour deposition,* CVD) wird an der erhitzten Oberfläche eines Wafers aufgrund einer chemischen Reaktion aus der Gasphase eine Feststoffkomponente abgeschieden. Voraussetzung hierfür ist, dass flüchtige Verbindungen der Schichtkomponenten existieren, die bei einer bestimmten Reaktionstemperatur die feste Schicht abscheiden. Das Verfahren der chemischen Gasphasenabscheidung zeichnet sich durch mindestens eine Reaktion an der Oberfläche des zu beschichtenden Werkstücks aus. An dieser Reaktion muss mindestens eine gasförmige Ausgangsverbindung (Edukt) und mindestens zwei Reaktionsprodukte - davon mindestens eines in der festen Phase - beteiligt sein. Um gegenüber konkurrierenden Gasphasen-Reaktionen jene Reaktionen an der Oberfläche zu fördern und damit die Bildung von festen Partikeln zu vermeiden, werden Prozesse chemischer Gasphasenabscheidung zumeist bei reduziertem Druck betrieben (typisch: 1-1000 Pa). Eine besondere Eigenschaft des Verfahrens ist die konforme Schichtabscheidung, wodurch auch z. B. feinste Vertiefungen in Wafern gleichmäßig beschichtet werden.

Umfasst von der chemischen Gasphasenabscheidung ist auch die Atomlagenabscheidung. Bei der Atomlagenabscheidung(englisch *atomic layer deposition,* ALD) handelt es sich um ein stark verändertes Chemisches Gasphasenabscheidungs- (CVD-) Verfahren mit zwei oder mehr zyklisch durchgeführten selbstbegrenzenden Oberflächenreaktionen. Das abzuscheidende Material ist in chemischer Form an ein oder mehrere Trägergase, den sogenannten Präkursoren gebunden. Diese Präkursore werden alternierend in eine Reaktionskammer geleitet und dort zur Reaktion mit dem Wafer gebracht, woraufhin der im Gas gebundene Stoff sich auf dem Substratmaterial abscheidet. Die so entstehenden Schichten haben in der Regel eine polykristalline oder amorphe Struktur.

Die plasmagestützte chemische Beschichtungsanlage bezeichnet bevorzugt eine Anlage, die das Verfahren der plasmagestützten oder plasmaunterstützten chemischen Gasphasenabscheidung nutzt. Die plasmaunterstützte chemische Gasphasenabscheidung (englisch *plasma-enhanced chemical vapour deposition,* PECVD; auch *engl.plasma-assisted chemical vapour deposition,* PACVD, genannt) ist eine Sonderform der chemischen Gasphasenabscheidung (CVD), bei der die chemische Abscheidung durch ein Plasma unterstützt wird. Das Plasma kann direkt beim zu beschichtenden Wafer (Direktplasma-Methode) oder in einer getrennten Kammer (Remote-Plasma-Methode) brennen.

Während bei der CVD die Dissoziation der Moleküle des Gases durch externe Zufuhr von Wärme sowie die freigewordene Energie der folgenden chemischen Reaktionen geschieht, übernehmen diese Aufgabe bei der PECVD beschleunigte Elektronen im Plasma. Zusätzlich zu den auf diese Weise gebildeten Radikalen werden in einem Plasma auch lonenerzeugt, die zusammen mit den Radikalen die Schichtabscheidung auf dem Wafer bewirken. Die Gastemperatur im Plasma erhöht sich dabei in der Regel nur um wenige Hundert Grad Celsius, wodurch im Gegensatz zur CVD auch temperaturempfindlichere Materialien beschichtet werden können. Bei der Direktplasma-Methode wird zwischen dem zu beschichtenden Wafer und einer Gegenelektrode ein starkes elektrisches Feld angelegt, durch das ein Plasma gezündet wird. Bei der Remote-Plasma-Methode ist das Plasma so angeordnet, dass es keinen direkten Kontakt zum Substrat hat. Dadurch erzielt man Vorteile bzgl. selektiver Anregung von einzelnen Komponenten eines Prozessgasgemisches und verringert die Möglichkeit einer Plasmaschädigung der Waferoberfläche durch die Ionen.

Niederdruck-CVD (engl.: low pressure chemical vapour deposition, LPCVD) ist das in der Halbleitertechnologie häufig eingesetzte Verfahren zur Abscheidung von Siliciumoxid, Siliciumnitrid und poly-Silicium, sowie von Metallen.

In einer bevorzugten Ausführungsform wird innerhalb der Beschichtungsanlage eine Abdeckschicht mindestens über einen Bereich der Öffnung, bevorzugt um die gesamte Referenzkammer, aufgetragen wird, wobei als Material für die Abdeckschicht bevorzugt ein Nitrid, bevorzugt einem Siliziumnitrid, Siliziumcarbonnitrid, Siliziumoxynitrid, Titannitrid und/oder Tantalnitrid, ein Oxid, bevorzugt ein Siliziumoxid, Aluminiumoxid, Siliziumdioxid, Titandioxid oder Tantaloxid, oder ein Metall, bevorzugt einem Aluminium und/oder einem Edelmetall, bevorzugt Gold, Platin, Iridium, Palladium, Osmium, Silber, Rhodium und/oder Ruthenium, verwandt wird.

Die Abdeckschicht über die gesamte Referenzkammer liefert vorteilhafterweise eine besonders gute hermetische Abriegelung der Referenzkammer. Damit bleibt vorteilhafterweise das Referenzgas besonders gut verschlossen im Volumen der Referenzkammer. So wird mit besonders hoher Zuverlässigkeit sichergestellt, das Gas aus dem Volumen der Referenzkammer dieses nach dem Verschluss nicht verlassen kann, insbesondere wenn die Abdeckschicht im Wesentlichen entlang der bzw. um die Referenzkammer beschichtet wurde.

Vorteilhafterweise ist die Referenzkammer auch von außen, d. h. von ihrer Umgebung, und insbesondere nach dem Herstellungsverfahren bei zusätzlich durch die Abdeckschicht geschützt. Damit wird auch das Risiko äußerlicher Schäden minimiert, z. B. durch Kontamination eines Fluids und durch eine mechanische Wirkung.

Die oben genannten Materialien lassen sich zum einen einfach prozessieren und somit zum Auftragen einer Abdeckschicht verwenden. Zudem stellen die Materialien aufgrund ihre Blockadeeigenschaften eine zuverlässige und auch langzeitstabile Barriere gegenüber einem Austritt des Referenzgases und/oder einem Eintritt von Fremdgase dar.

In einer bevorzugten Ausführungsform wird zum Verschließen der Öffnung und zur Ausbildung einer Abdeckschicht ein Prozessgas in der Beschichtungsanlage eingeführt, wobei das Prozessgas nach dem Befluten eines Referenzgases in die Referenzkammer eingeführt wird oder wobei ein Material zur Ausbildung der Abdeckschicht derart gewählt wird, dass das Referenzgas gleichzeitig als Prozessgas dienen kann.

Im Sinne der Erfindung bezeichnet das Prozessgas bevorzugt ein Gas, welches dazu dient, dass die Beschichtung im darauffolgenden Verfahrensschritt durch die Abdeckschicht geschieht. Das Auftragen bzw. Haften der Abdeckschicht an der Referenzkammer geschieht über eine physikalische und/oder chemische Reaktion. Bevorzugt hilft oder ermöglich das Prozessgas bei dieser physikalischen und/oder chemischen Reaktion, dass die Abdeckschicht auf der Referenzkammer beschichtet werden kann.

Insbesondere im Falle der Beflutung eines zusätzliches Prozessgases mit dem Referenzgas ist eine diffusionslimitierende oder diffusionsblockierende Öffnung erwünscht. Vorteilhafterweise wird dies durch das erfindungsgemäße Verfahren mit Anbringen eines diffusionsblockierenden Lotes oder Ventils oder einer diffusionslimitierenden Öffnung im lateralen Bereich der Referenzkammer beim Bondprozess mit den entsprechenden Maßen erreicht. Vorteilhafterweise kann über diese Öffnungen zunächst bevorzugt das Referenzgas in das Volumen der Referenzkammer gelangen. Im Anschluss kann ein Gasaustausch innerhalb der Beschichtungsanlage folgen, sodass nach Einführen eines Prozessgases der Beschichtungsprozess erfolgt. Sowohl während des (zumindest partiellen) Gasaustausches von einem Referenzgases zu einem Prozessgases wird durch die diffusionslimitierende bzw. diffusionsblockierende Öffnung gewährleistet, dass das Referenzgas nicht austritt. Für bestimmte Anwendungen kann es auch bevorzugt sein, dass kein zusätzliches Prozessgas in die Beschichtungsanlage geflutet wird, sondern, dass das Referenzgas dem Prozessgas entspricht. Bevorzugt ist dies für Ammoniak als Referenzgas der Fall, welches insbesondere für eine Abdeckschicht umfassend Nitrid-Verbindungen als Prozessgas dienen kann.

Vorteilhaft muss in dem Fall kein Gastausch in der Beschichtungsanlage erfolgen. Vielmehr kann sich nahtlos an die Beflutung der Referenzkammer mit Referenzgas der Beschichtungsschritt anschließen. In bevorzugten Ausführungsformen ist Ammoniak das Prozessgas, welches gleichzeitig als Referenzgas fungiert, d. h. als Gas für die Befüllung der Referenzkammer. Vorteilhaft kann durch den Einsatz von Ammoniak als Prozessgas eine Abdeckschicht umfassend Nitrid-Verbindungen besonders effizient für den hermetischen Einschluss des Referenzgases dienen, da es nicht notwendig ist, ein weiteres Gas als Prozessgas für die Bindung zwischen der Abdeckschicht und der Referenzkammer in die Beschichtungskammer einzubringen. Im Hinblick auf die Beibehaltung des Referenzgases innerhalb der Beschichtungsanlage kann die gewünschte Konzentration des Referenzgases innerhalb der Kammer besonders präzise eingestellt werden. Ein unerwünschtes Diffundieren eines vom Referenzgas verschiedeneren Prozessgases in die Kammer wird durch die geschickte Wahl der Prozessparameter inhärent verhindert.

Gemäß der Erfindung ist das MEMS-Bauteil ein MEMS-Sensor und/oder MEMS-Aktuator und/oder die elektronische Schaltung umfasst einen Prozessor, einen Schalter, Transistoren, und/oder Transducer.

Der MEMS-Sensor oder MEMS-Aktuator bezeichnet insbesondere ein Sensor oder Aktuator in Form eines Mikrosystems (engl. *Micro-Electro-Mechanical System,* kurz MEMS). Ein Mikrosystem ist insbesondere ein miniaturisiertes Gerät, eine Baugruppe und/oder ein Bauteil, wobei die Komponenten Abmessungen im Mikrometerbereich (1 µm bis 1000 µm) oder kleiner haben und als System zusammenwirken. Der MEMS-Sensor ist z. B. ein Schalldetektor.

In einer weiteren Ausführungsform umfasst das MEMS-Bauteil einen Schalldruckdetektor, wobei der Schalldruckdetektor bevorzugt einen kapazitiv oder optisch auslesbaren, piezoelektrischen, piezoresistiven und/oder magnetischen Balken und/oder ein kapazitives, piezoelektrischen, piezoresistives und/oder optisches Mikrofon umfasst.

Die Ausführungsform ist insbesondere für die Verwendung der Referenzkammer in der PAS geeignet, wobei die Schalldruckwellen durch den Schalldruckdetektor unmittelbar in der Referenzkammer detektiert werden können.

Ein piezoelektrischer Balken ist vorzugweise eine schwingfähige Struktur, insbesondere in Form eines Biegebalkens, welcher ein piezoelektrisches Material, z. B. in Form eines Aktuators, umfasst.

Dabei kann es bevorzugt sein, dass der Biegebalken passiv ist, das bedeutet bevorzugt, dass er durch die Schalldruckwellen zu einer Schwingung veranlasst wird. Diese erzeugen dabei wiederum durch die Verformung des piezoelektrischen Materials eine Spannung, welche auf dem piezoelektrischen Effekt beruht. Der (direkte) piezoelektrische Effekt beschreibt bevorzugt das Auftreten einer elektrischen Spannung und/oder eine Änderung der Impedanz an einem aus entsprechendem Material gefertigten Festkörper, wenn er elastisch verformt wird. Die Spannung kann z. B. durch geeignete Kontaktierung abgegriffen und durch eine entsprechende elektronische Schaltung ausgelesen werden.

Es kann ebenso bevorzugt sein, dass der Biegebalken aktiv ist, das bedeutet insbesondere, dass er aufgrund des inversen piezoelektrischen Effekts zu einer Schwingung veranlasst wird. Der piezoelektrische Effekt beschreibt bevorzugt die Verformung eines Materials bei Anlegen einer elektrischen Spannung und/oder eines elektrischen Feldes, wodurch insbesondere durch das Material eine Kraft ausgeübt werden kann. Durch die Schalldruckwellen kann dabei bevorzugt eine Variation der Dämpfung des schwingenden Balkens verursacht werden, welche messbar ist, z. B. durch eine Änderung der Resonanzfrequenz des schwingenden Balkens.

Ein passiv aufgrund von Schalldruckwellen schwingender Balken kann bevorzugt ebenso ausgelesen werden, z. B. durch kapazitive, magnetische und/oder piezoresistive Methoden. Die Idee dabei ist bevorzugt ebenfalls, dass durch die Schwingung eine elektrisch auslesbare Veränderung erzeugt wird, z. B. basierend auf einem sich ändernden magnetischen Fluss durch einen mitschwingenden Magneten, durch eine sich ändernde Kapazität zwischen einer schwingenden und einer feststehenden Elektrode und/oder durch einen sich ändernden elektrischen Widerstand in einem piezoresistiven Material.

Ein Mikrofon umfasst vorzugsweise eine schwingfähig gelagerte Membran, welche durch Schalldruckwellen zu Schwingungen angeregt wird, welche wiederum elektrisch auslesbar ist, ähnlich dem vorstehend beschriebenen Balken. Dabei können ebenfalls kapazitive, piezoelektrische und/oder piezoresistive Messmethoden der Schwingungsauslegung zur Anwendung kommen.

Bevorzugt kann ebenso ein optisches Mikrofon zur Anwendung kommen, wobei dies Schwingungen vorzugsweise durch Reflektion z. B. eines Laserstrahls auf der Membran in ein optisches Signal umgewandelt werden kann, welches z. B. in einer interferometrischen Anordnung ausgelesen wird.

In einem weiteren Aspekt betrifft die Erfindung einen photoakustischen Gassensor, wie in den beigefügten Ansprüchen dargelegt, herstellbar durch das erfindungsgemäße Verfahren.

In einer bevorzugten Ausführungsform der Erfindung weist die Referenzkammer eine Höhe von 10 µm bis 2 mm, bevorzugt von 50 µm bis 1 mm, besonders bevorzugt von 100 µm bis 500 µm auf.

So kann vorteilhafterweise eine flache und kompakte Bauweise, insbesondere eine geringe Bauhöhe der Referenzkammer erreicht werden.

In einer weiteren bevorzugten Ausführungsform weist die Referenzkammer eine Länge und/oder Breite von 100 µm bis 5 mm, bevorzugt von 200 µm bis 3 mm, besonders bevorzugt von 500 µm bis 2 mm auf.

Mit diesen Maßen ist es vorteilhafterweise möglich, ausreichend Volumen an Referenzgas in das Volumen der Referenzkammer zu führen. Gleichzeitig erlauben diese Abmessungen auch vorteilhafterweise, dass ein MEMS-Bauteil, bevorzugt ein MEMS-Sensor, besonders bevorzugt ein Schalldruckdetektor eingebaut werden kann, bevorzugt zur Anwendung in der PAS.

In einem weiteren Aspekt betrifft die Erfindung einen photoakustischen Gassensor wie in den beigefügten Ansprüchen dargelegt.

Der durchschnittliche Fachmann erkennt, dass technische Merkmale, Definitionen und Vorteile bevorzugter Ausführungsformen, welche für das erfindungsgemäße Herstellungsverfahren gleichermaßen für einen photoakustischen Gassensor gelten, welcher eine derartige Referenzkammer umfasst, bzw. für ein Herstellungsverfahren des Gassensors gelten und umgekehrt.

Insbesondere ermöglicht die Erfindung die Bereitstellung eines miniaturisierten photoakustischen Gassensors, welche als Referenzgase auch korrosive oder explosiver Gase (wie z.B. Ammoniak) sicher und hermetisch einschließt und somit eine Überwachung des Auftretens solcher gefährdender Gase in der Umgebungsluft ermöglicht. Das erfindungsgemäße Verfahren stellt dabei sicher, dass sensitive Bestandteile des photoakustischen Gassensor (wie beispielsweise der MEMS-Sensor) während des Einschlusses des Referenzgases nicht angegriffen werden. Auch wird ein Austreten der potentiell gefährdenden Gase aus der Referenzkammer durch einen hermetischen Einschluss vermieden, welche zudem aufgrund der kompakten Anordnung ein hohes Maß an Sicherheit gegenüber potentiellen Beschädigungen gewährleistet.

In einer bevorzugten Ausführungsform bildet die Referenzkammer des photoakustischen Gassensors ein geschlossenes System, welches mit dem Referenzgas gefüllt ist und wobei ein zu analysierendes Gas, vorzugsweise Umgebungsluft, im Strahlengang zwischen dem Emitter und der Referenzkammer vorliegt, sodass der Anteil des Referenzgases im zu analysierenden Gas anhand der Ausbildung von Schalldruckwellen in der Referenzkammer messbar ist.

Ein photoakustischer Gassensor ist dem Fachmann dabei in seinen Grundzügen bzw. wesentlichen Komponenten bekannt. Ein modulierbarer Emitter erzeugt elektromagnetische Strahlung und ist bevorzugt so angeordnet und konfiguriert, dass die von dem Infrarot-Emitter emittierte Strahlung im Wesentlichen oder zumindest teilweise auf das Gas in der Referenzkammer trifft.

Erfolgt die modulierte Bestrahlung mit einer Wellenlänge, welche dem Absorptionsspektrum eines in dem Gasgemisch befindlichen Moleküls einer Gaskomponente entspricht, findet eine modulierte Absorption statt, die zu Erwärmungs- und Abkühlungsprozessen führt, deren Zeitskalen die Modulationsfrequenz der Strahlung widerspiegeln. Gemäß dem photoakustischen Effekt führen die Erwärmungs- und Abkühlungsprozesse zu Expansionen und Kontraktion der Gaskomponente wodurch diese zur Ausbildung von Schalldruckwellen mit im Wesentlichen der Modulationsfrequenz angeregt wird. Die Schalldruckwellen werden auch als PAS-Signale bezeichnet und lassen sich mittels eines Sensors, beispielweise eines Schalldetektors, messen. Die Leistung der Schallwellen ist dabei vorzugsweise direkt proportional zur Konzentration der absorbierenden Gaskomponente.

Unter dem Begriff Gaskomponente wird bevorzugt der Anteil chemisch (und spektroskopisch) gleicher Gasmoleküle (z. B. Ammoniak) in einem Gasgemisch verstanden, während das Gasgemisch die Gesamtheit bzw. das Gemisch aus mehrerer (bevorzugt unterschiedlichen) Gaskomponenten meint (z.B. Luft).

Verschiedene Emitter kommen bevorzugt als Strahlungsquelle für die genannten Anwendungen in Frage. Es können beispielsweise schmalbandige Laserquellen verwendet werden. Diese erlauben vorteilhafterweise die Verwendung hoher Strahlungsintensitäten und können mit Standardkomponenten für die photoakustische Spektroskopie vorzugsweise hochfrequent moduliert werden.

Bevorzugt können ebenso breitbandige Emitter verwendet werden. Diese weisen vorteilhafterweise ein breites Spektrum auf, welches sich z. B. durch den Einsatz von (durchstimmbaren) Filtern weiter selektieren lässt.

In einer bevorzugten Ausführungsform der Erfindung ist der modulierbare Emitter ein thermischer Emitter und umfasst ein Heizelement, wobei das Heizelement ein Substrat umfasst, auf welchem mindestens teilweise eine erhitzbare Schicht aus einem leitfähigen Material aufgebracht ist, an welchem Kontakte für eine Strom- und/oder Spannungsquelle vorliegen.

Dabei umfasst das Heizelement eine erhitzbare Schicht aus einem leitfähigen Material, welches bei Durchfluss eines elektrischen Stroms joulesche Wärme produziert. Das Heizelement umfasst insbesondere ein Substrat, auf dem die erhitzbare Schicht vorliegt. Das Substrat bildet bevorzugt die Basis des Heizelements. Dabei kann das Substrat auch weitere Elemente des IR-Emitters, wie beispielsweise Grundelement und/oder Gehäuseelemente zumindest teilweise umfassen. Das Substrat kann vorteilhafterweise durch etablierte Prozessschritte, insbesondere aus der Halbleiter- und/oder Mikrosystemherstellung, geeignet geformt werden. Die vorstehend genannten Materialien sind in der Halbleiter- und/oder Mikrosystemherstellung besonders einfach und kostengünstig zu bearbeiten und eignen sich ebenfalls gut für eine Massenherstellung. Ebenso sind diese Materialien für ein Dotieren und/oder Beschichten besonders geeignet, um in bestimmten Bereichen die gewünschten elektrischen, thermischen und/oder Strahlungseigenschaften zu erzielen.

Das Substrat kann bevorzugt ausgewählt sein aus einer Gruppe umfassend Silizium, monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid und/oder Indiumphosphid.

Das leitfähige Material zur Bildung der erhitzbaren Schicht kann bevorzugt ausgewählt sein aus der Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit und/oder Kupfer. Diese Materialien weisen zum einen die gewünschten thermischen, elektrischen, mechanischen und/oder Strahlungseigenschaften auf und sind darüber hinaus besonders leicht und kostengünstig zu verarbeiten.

Das (Mikro-) Heizelement ist bevorzugt zumindest teilweise freistehend und erlaubt z. B. innerhalb des IR-Emitters thermische Dehnungen aufgrund von starken Temperaturänderungen sowie Translationsbewegungen. Teilweise freistehend bedeutet, dass es an den Grenzflächen zumindest teilweise nicht kraft- und/oder formschlüssig mit anderen Elementen des Emitters verbunden ist und daher einen Freiheitsgrad der Bewegung in eine im Wesentlichen zur Grenzfläche senkrechten Richtung aufweist.

Der Emitter ist modulierbar, das bedeutet, dass die Intensität der emittierten Strahlung, bevorzugt die Intensität des Strahls im zeitlichen Verlauf kontrollierbar geändert werden kann. Die Modulation soll bevorzugt eine zeitliche Änderung der Intensität als messbare Größe hervorrufen. Das bedeutet z. B., dass die Intensität im zeitlichen Verlauf zwischen der innerhalb des Messzeitraums gemessenen schwächsten Intensität und der innerhalb desselben Zeitraums gemessenen stärksten Intensität ein Unterschied besteht, der größer ist als die Sensibilität eines für das Strahlungsspektrum und die Anwendung typischerweise verwendeten Geräts zur Messung oder Bestimmung der Intensität. Bevorzugt ist der Unterschied deutlich größer als ein Faktor 2, mehr bevorzugt 4, 6 oder 8 zwischen der stärksten und der schwächsten einstellbaren Intensität. Besonders bevorzugt erfolgt die Modulation der Intensität des modulierten Strahles für eine oder mehrere vorbestimmte Resonanzwellenlängen.

Vorzugsweise kann eine direkte Modulation durch Variation der Stromzufuhr vorgenommen werden. Bei einem thermischen Emitter ist eine solche Modulation aufgrund thermischer Zeitkonstanten meistens auf einen bestimmten Bereich eines Modulationsspektrums limitiert, z. B. im Bereich einer Größenordnung von bis zu 100 Hz. Bei z. B. einem Laser oder einer LED sind bevorzugt deutlich höhere Modulationsraten, z. B. im kHz-Bereich und darüber hinaus, möglich.

Eine Modulation des Infrarot-Emitters kann vorzugsweise ebenso durch eine externe Modulation erfolgen, z. B. durch die Verwendung eines sich drehend Chopperrads und/oder eines elektrooptischen Modulators.

Ein modulierbarer Emitter bezeichnet bevorzugt eine Vorrichtung, die elektromagnetische Strahlung in einem Wellenlängenbereich innerhalb eines bestimmten Spektrums aussendet. Das Spektrum ist insbesondere so gewählt, dass es dem bevorzugten Anwendungsgebiet des Emitters, nämlich der photoakustischen Spektroskopie entspricht. Dabei ist insbesondere die Schwingungsanregung der zu spektroskopierenden und/oder zu detektierenden Gasmoleküle bevorzugt, welche je nach Gasmolekülen einem bevorzugten spektralen Bereich entsprechen.

Die Emission des IR-Emitters erfolgt bevorzugt als Strahl, welcher in einer bevorzugten Richtung in Form einer Grade orientiert ist. Der Begriff Strahl soll den vorzugsweise gebündelten Teil der Strahlung entlang der bevorzugten Strahlrichtung des Emitters beschreiben, welcher vom Emitter ausgesandt wird, wobei insbesondere die Bereiche der größten Intensität entlang dieser Richtung den Strahl definieren. Intensität ist bevorzugt definiert als Flächenleistungsdichte und hat bevorzugt die Einheit Watt pro Quadratmeter oder abgekürzt W/m².

Es können zusätzliche Komponenten wie z. B. Linsen im Emitter integriert oder extern angebracht sein, die für eine Bündelung bzw. Kollimation des Strahls sorgen. Ein Fachmann weiß, wie er durch das Design des Emitters sowie durch Verwendung weiterer Komponenten das Emissionsprofil der Strahlungsquelle so formt, dass ein gewünschtes Strahlprofil sowie eine gewünschte Strahlrichtung resultieren. Dabei kann der modulierbare Emitter bevorzugt ohne zusätzliche Linsen auskommen, oder als ein System umfassend Strahlungsquelle und mindestens einer Linse zur Kollimation des Strahls vorliegen.

Gemäß der Erfindung liegt die Referenzkammer im Strahlengang des Emitters vor. Das bedeutet, dass die Intensität des Strahls im Wesentlichen oder zumindest teilweise auf die dem Emitter zugewandte Seite der Referenzkammer trifft. Teilweise bedeutet bevorzugt zu mindestens 40 %, bevorzugt mindestens 50%, 60% oder mehr. Es bedeutet insbesondere, dass der Bereich des Maximums der Intensität des Strahls auf die Detektionskammer trifft. Bevorzugt bedeutet es, dass der Strahl so fokussiert und/oder kollimiert ist, dass ein wesentlicher Anteil der Intensität auf der dem Emitter zugewandten Seite auftrifft. Als bevorzugtes Beispiel sein ein Gauß-Strahl genannt, welcher insbesondere ein transversales Profil gemäß einer Gauß-Kurve aufweist. Entlang des Strahls ist dabei bevorzugt durch die Strecke mit der maximalen Intensität als z-Achse definiert. Der Strahlradius w auf der "Höhe" z des Strahls ist dabei bevorzugt definiert als der Abstand zur z-Achse, an dem die Intensität auf 1/e² (bevorzugt ca. 13,5 %), gefallen ist. Dieser Definition folgend ist bevorzugt, dass "die Referenzkammer im Strahlengang des Emitters vorliegt" bedeutet, dass der im Wesentlichen der gesamte Strahlradius auf der dem Emitter zugewandten Seite der Referenzkammer auftrifft.

Bevorzugt ist die dem Emitter zugewandte Seite der Referenzkammer für die emittierte Strahlung transparent, so dass die Strahlung im Wesentlichen den mit Gas befüllbaren Innenraum der Kammer erreicht. Die dem Emitter zugewandte Seite insbesondere der Referenzkammer wird vorzugsweise auch als Einstrahlfläche bezeichnet.

Dass die Referenzkammer im Strahlengang des Infrarot-Emitters vorliegt, bedeutet, dass der Emitter mittels modulierbar emittierbarer Strahlung Gas in der Detektionskammer zur Ausbildung von Schalldruckwellen anregen kann, da diese zumindest teilweise (bevorzugt zu mindestens 40 %, stärker bevorzugt zu mindestens 50 %, insbesondere zu mindestens 60 %) bestrahlt wird und insbesondere eine wesentlicher Teil der Strahlung das mit Gas befüllbare Volumen im Inneren der Detektionskammer erreicht. Ein wesentlicher Teil bedeutet insbesondere zu mindestens 80 %, stärker bevorzugt zu 90 % und insbesondere zu 95 %.

Begriffe wie im Wesentlichen, ungefähr, etwa, ca. etc. beschreiben bevorzugt einen Toleranzbereich von weniger als ± 20%, bevorzugt weniger als ± 10 %, noch stärker bevorzugt weniger als ± 5% und insbesondere weniger als ± 1%. Angaben von im Wesentlichen, ungefähr, etwa, ca. etc. offenbaren und umfassen stets auch den exakten genannten Wert. Die Referenzkammer enthält ein Referenzgas, welches auf den IR-Emitter dergestalt abgestimmt ist, dass in die Referenzkammer eindringende, modulierte IR-Strahlung eine PAS mithilfe der dortigen Gasmoleküle des Referenzgases ermöglicht. Ist nun in der Messstrecke zwischen dem Infrarotemitter und der Referenzkammer ebenfalls anteilig Referenzgas in der zu analysierenden Luft (insbesondere Umgebungsluft) enthalten, welches die IR-Strahlung absorbiert findet PAS statt. Die Stärke der Absorption in der Referenzkammer wird hierdurch vermindert.

Durch die Größe der Minderung lässt sich auf die Konzentration des Referenzgases in der Messstrecke schließen. Dabei ist vorzugsweise die Ausbildung von Schalldruckwellen in der Referenzkammer umso kleiner, umso mehr vom Referenzgas im Strahlengang außerhalb der Detektionskammer vorhanden ist, da dann insbesondere bereits dort eine Absorption und eine Anregung stattfindet. Bevorzugt wird hierbei ein schmalbandiger IR-Emitter eingesetzt, damit möglichst nur das Referenzgas angeregt werden kann.

Durch diese Messprinzip können kleinste Konzentrationen von Molekülen eines Referenzgases innerhalb der Umgebungsluft detektiert werden. Die Überwachung toxischer, korrosiver oder explosiver Gase, wie Ammoniak, ist mithin besonders sicher und zuverlässig möglich.

Vorteilhaft gewährleistet das Messprinzip inhärent zudem eine Fehlerkontrolle bzw. einen Fehleralarm. Nur sofern der Gassensor korrekt arbeitet, wird zuverlässig ein PAS-Signal detektiert, welche in Abwesenheit auffälliger Ammoniak-Konzentration in der Umgebungsluft der erwarteten maximale Amplituden aufweist. Für den Überwachungsbereich lassen sich Grenzwerte definieren, welche zulässige Konzentration von Ammoniak entsprechen.

Sofern der Schalldetektor, Emitter oder eine andere Komponente fehlerhaft sind, wird dies als Änderung an dem erwarteten PAS-Signal detektiert. Eine Warnung kann automatisch ausgegeben werden. Je nach Abweichung vom PAS-Signal kann die Warnmeldung auf eine vermutlich fehlerhafte Funktion des Gassensors und/oder unzulässige Grenzwerte verweisen.

Die Warnung muss somit nicht erst von einer WatchDog-Funktion oder ähnlichem ausgeben, sondern liegt dem Messprinzip inhärent zu Grunde. Das Ausbleiben einer Warnung und ein unentdeckter Anstieg an potentiell gefährlichen Konzentrationen wird wirksam vermieden.

Bevorzugt umfasst der Gassensor darüber hinaus eine Steuer- bzw. Regeleinheit, welche dazu konfiguriert ist, den modulierbaren Emitter und/oder den MEMS-Sensor zu steuern sowie Daten von dem modulierbaren Emitter und/oder dem MEMS-Sensor zu empfangen und ggf. auszuwerten.

Die Steuereinheit kann bevorzugt eine beschriebene elektronische Schaltung umfassen, welche sich innerhalb der Referenzkammer befindet und mit dem MEMS-Sensor verbunden ist. Darüber hinaus ist es bevorzugt, dass die Steuereinheit mindestens eine (externe) Datenverarbeitungseinheit (z.B. integrierte Schaltung (IC), ein Anwendungsspezifische integrierte Schaltungen (ASIC), eine programmierbare logische Schaltung (PLD), ein Field Programmable Gate Array (FPGA), einen Mikroprozessor, einen Mikrocomputer, eine speicherprogrammierbare Steuerung und/oder eine sonstige elektronische, bevorzugt programmierbare, Schaltung) umfasst, welche sich außerhalb der Referenzkammer befindet und mit der elektronischen Schaltung innerhalb der Referenzkammer verbunden ist.

Beispielsweise kann es bevorzugt sein, dass die Steuereinheit einerseits mittels der externen Datenverarbeitungseinheit elektrische Steuersignale ausgibt, welche den modulierbaren Emitter und den MEMS-Sensor ansteuern. Anderseits kann bevorzugt mittels der externen Datenverarbeitungseinheit eine Auswertung der vom MEMS-Sensor aufgezeichneten Messdaten (insbesondere Messdaten zum PAS-Signal) erfolgt. Die interne elektronische Schaltung kann ebenfalls bereits eine (Vor-)auswertung der Messdaten des MEMS-Sensors leisten. Es kann aber auch bevorzugt sein, dass die interne elektronische Schaltung im Wesentlichen die Messdaten unprozessiert an die externe Datenverarbeitungseinheit zur weiteren Verarbeitung und/oder Auswertung weiterleitet.

### Detaillierte Beschreibung

Im Folgenden soll die Erfindung an Hand von Beispielen näher erläutert werden, ohne auf diese beschränkt zu sein.

### Kurzbeschreibung der Abbildungen

**Fig. 1** **A - B** Schematische Übersichtsdarstellung einer ersten bevorzugten Ausführungsform eines Verfahrens zur Bildung einer mit Referenzgas gefüllten Referenzkammer bei an der an den Kontaktflächen der Wafer nach dem Bonden eine Öffnung verbleibt.
**Fig. 2** **A - K** Schematische Illustration von bevorzugten Verfahrensschritten der ersten bevorzugten Ausführungsform des Herstellungsverfahrens einer mit Referenzgas gefüllten Referenzkammer, bei der an den Kontaktflächen der Wafer nach dem Bonden eine Öffnung verbleibt.
**Fig. 3** **A - B** Schematische Übersichtsdarstellung einer zweiten bevorzugten Ausführungsform eines Verfahrens zur Bildung einer mit Referenzgas gefüllten Referenzkammer, welche eine Ventil aufweist.
**Fig. 4** **A - B** Schematische Illustration von bevorzugten Verfahrensschritte der zweiten bevorzugten Ausführungsform eines Herstellungsverfahrens einer mit Referenzgas gefüllten Referenzkammer, welche ein Ventil aufweist.
**Fig. 5** **A - B** Schematische Übersichtsdarstellung einer dritten bevorzugten Ausführungsform eines Verfahrens zur Bildung einer mit Referenzgas gefüllten Referenzkammer deren Öffnung mit einem thermischen Lot verschlossen wird.
**Fig. 6** **A - H** Schematische Illustration von bevorzugten Verfahrensschritte der dritten bevorzugten Ausführungsform eines Herstellungsverfahrens einer mit Referenzgas gefüllten Referenzkammer, deren Öffnung mit einem thermischen Lot verschlossen wird.

### Ausführliche Beschreibung der Abbildungen

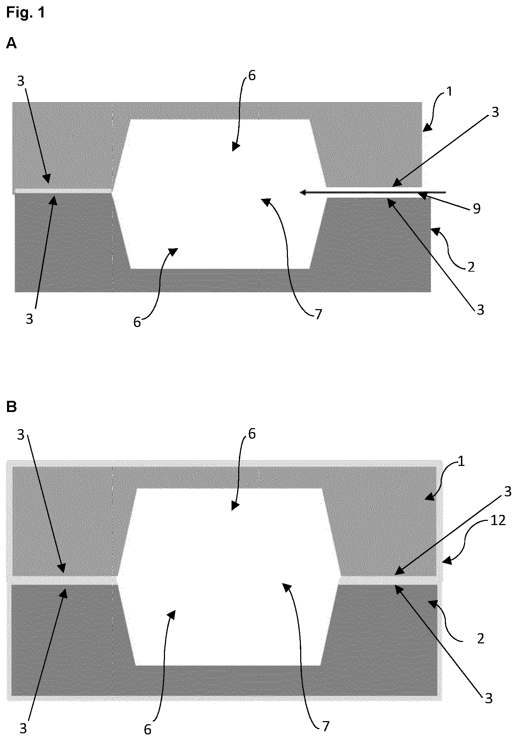

**Fig. 1** **A - B** zeigt eine zusammenfassende Darstellung einer ersten Variante eines Herstellungsverfahrens.

Hierbei werden ein erster Wafer **1** und ein zweiter Wafer **2** bereitgestellt, wobei vorliegend sowohl der erste (obere) Wafer **1** als auch der zweite (untere) Wafer **2** jeweils eine Kavität **6** aufweist. Auf dem ersten **1** und/oder zweiten Wafer **2** liegt ein MEMS-Bauteil und/oder eine elektronische Schaltung vor (beispielsweise innerhalb der Kavitäten, jedoch nicht gezeigt).

Das Bonden des ersten Wafers **1** mit dem zweiten Wafer **2** erfolgt innerhalb einer Bondkammer zur Bildung eines mit Referenzgas **11** befüllbaren Volumens **7,** wobei nach dem Bonden an einer Kontaktfläche **3** der beiden Wafer einen Öffnung **9** verbleibt. Der erste Wafer **1** und der zweite Wafer **2** weisen zudem zu diesem Zweck bevorzugt Kontaktflächen **3** auf, die zum Bonden des ersten Wafers **1** mit dem zweiten Wafer **2** dienen, wobei zum Bilden der Öffnung **9** ein Bereich an den Kontaktflächen **3** nicht gebondet wird.

In **Fig. 1** **A** ist der nicht gebondete laterale Bereich der Referenzkammer auf der rechten Seite illustriert, wodurch eine Öffnung **9** bereitgestellt werden kann. Ein Befluten eines Referenzgases **11** in die Referenzkammer über die Öffnung **9** kann wie beschrieben innerhalb einer Beschichtungsanlage erfolgen. In Fig. 1 A ist der Schritt des Beflutens als ein Pfeil illustriert.

Das Verschließen der Öffnung **9** der Referenzkammer innerhalb der Beschichtungsanlage erfolgt in der bevorzugten Ausführungsform durch ein Beschichtungsverfahren, welches eine Abdeckschicht **12** mindestens über einen Bereich der Öffnung, wie in Fig. 1B illustriert, bevorzugt um die gesamte Referenzkammer aufträgt. Bei der Abdeckschicht **12** kann es sich bevorzugt um ein Nitrid handeln, welches zuverlässig die gesamte Referenzkammer hermetisch abriegelt.

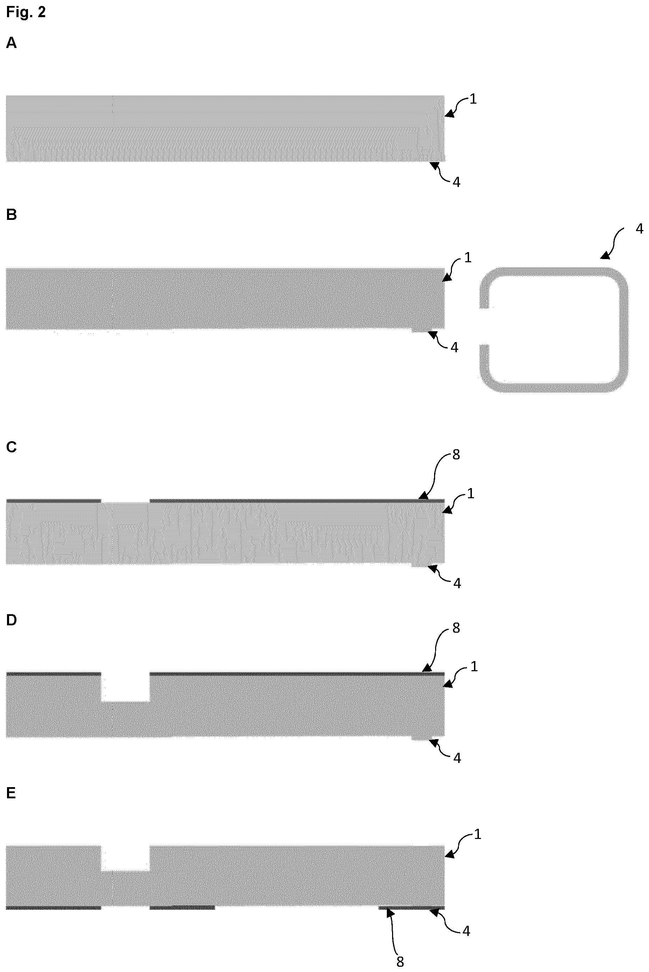

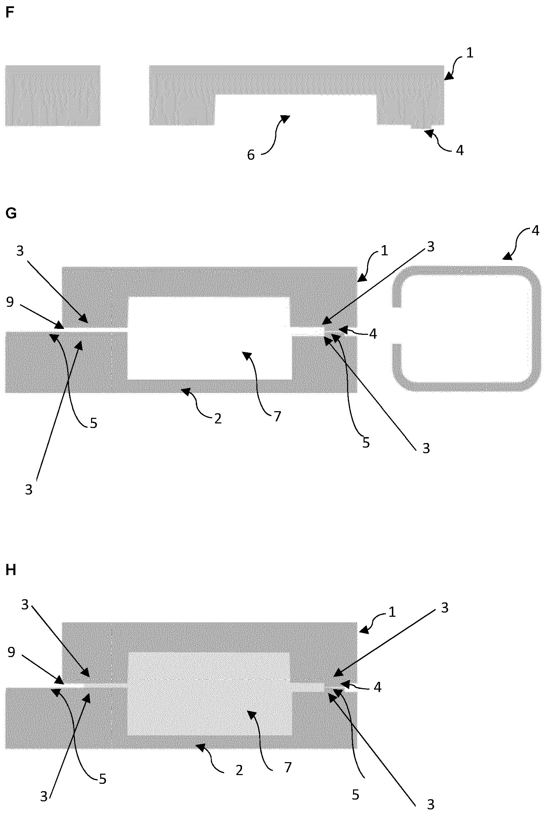

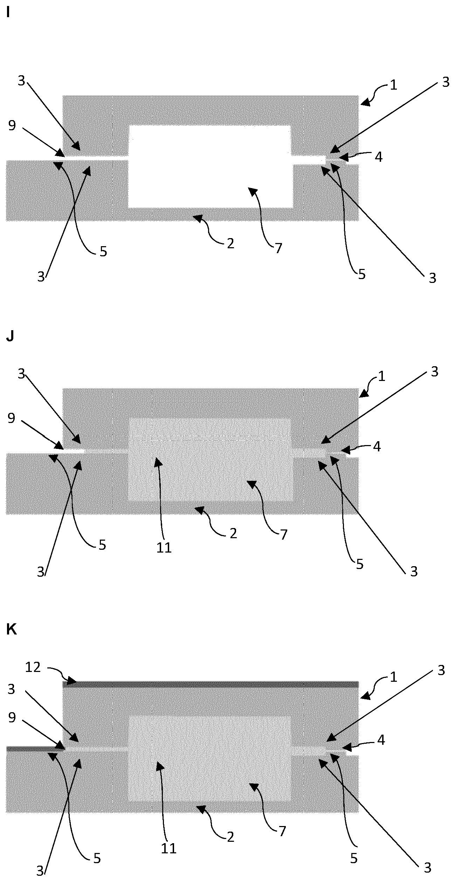

**Fig.** 2 **A - K** zeigt bevorzugte Verfahrensschritte einer ersten Variante eines Herstellungsverfahrens zur Bildung einer mit Referenzgas **11** gefüllten Referenzkammer, bei an der an den Kontaktflächen **3** der Wafer nach dem Bonden eine Öffnung verbleibt.

Wie in **Fig. 2** **A** illustriert, kann in einem ersten Verfahrensschritt der erste Wafer **1** mit einem ersten Bondmaterial **4** rückseitig besputtert werden. Das erste Bondmaterial **4** kann bevorzugt Gold sein. Dabei bezeichnet Bondmaterial ein Material, welches bevorzugt zum Bonden geeignet ist.

In **Fig. 2** **B** wird eine bevorzugte Strukturierung des ersten Bondmaterials **4** illustriert. Auf der linken Seite ist ein mittiger Querschnitt durch die zu bildende Referenzkammer zu sehen. Auf dem rechten Bild wird zusätzlich eine Draufsicht illustriert. Das strukturierte erste Bondmaterials **4** bildet eine nahezu geschlossene Umrandung, welche jedoch auf der linken Seite eine Aussparung aufweist. Die Aussparung wird nicht gebondet, sondern dient der Bildung der Öffnung in die Referenzkammer.

Eine Strukturierung des ersten Wafers **1** erfolgt mittels eines Fotolacks **8** und Ätzprozessen, wie in den Fig. 2C bis Fig. 2 F illustriert.

In **Fig. 2** **C** wird ein Fotolack **8** vorderseitig am ersten Wafers **1** aufgebracht, wobei ein Bereich zur weiteren Bearbeitung freigehalten wird. Über einen Ätzprozess, bevorzugt über ein reaktives lonentiefätzen (englisch deep reactive ion etching, DRIE), wird der Bereich des ersten Wafers **1** geätzt, wie in **Fig. 2** **D** dargestellt. Allerdings wird der erste Wafer bevorzugt nicht durchgängig geätzt. In **Fig. 2** **E** wird ein Fotolack **8** auf der Rückseite des ersten Wafers **1** angebracht. Es kann dasselbe Fotolack **8** sein, wie in den vorherigen Schritten, oder ein anderer. Ausgehend von der Rückseite findet erneut ein Ätzprozess (bevorzugt DRIE) an der betreffenden Stelle statt (vgl. **Fig. 2 F****),** um den ersten Wafer **1** an dem zuvor vorderseitig geätzten Bereich zu durchtrennen. Zudem wird durch den rückseitigen Ätzprozess eine Kavität **6** in den ersten Wafer **1** angebracht, welche zur Ausbildung des Volumens **7** in der Reaktionskammer dienen kann.

In **Fig 2** **G** wird der erste Wafer **1** mit dem zweiten Wafer **2** gebondet, auf dem sich ein zweites Bondmaterial **5** befindet. Der zweite Wafer **2** weist ebenfalls eine Kavität **6** auf, welche komplementär zur Kavität **6** des ersten Wafers **1** ausgestaltet ist. Die Bereitstellung des zweiten Wafers **2** kann mittels analoger Ätzprozesse erfolgen.

Das zweite Bondmaterial **5** kann bevorzugt Aluminium, Kupfer und/oder Gold sein. Das zweite Bondmaterial **5** kann, muss aber nicht strukturiert vorliegen. Um das Bonden an der zu bildenden Öffnung **9** zu vermeiden, reicht es, dass das erste Bondmaterial **4** des ersten Wafers **1** an der linken Seite eine Aussparung aufweist. Vorzugsweise werden der erste Wafer **1** und der zweite Wafer **2** über Thermokompressionsbonden (kurz: TC - Bonden) miteinander gebondet. Allerdings wird der linke Bereich an Kontaktflächen **3** nicht gebondet.

In dieser bevorzugten Ausführungsform des Verfahrens wird der Bereich an nicht-gebondeten Kontaktflächen als Öffnung **9** genutzt, um die Referenzkammer mit einem Referenzgas **11,** z. B. Ammoniak, zu befüllen Somit wird eine Referenzkammer hergestellt, welches ein Volumen **7** beinhaltet und eine Öffnung **9** besitzt. Dabei befindet sich die Öffnung **9** in einem lateralen Bereich der Referenzkammer und wird dadurch bereitgestellt, dass in diesem Bereich kein Bondprozess stattfindet.

In der **Fig. 2** **G** ist die Öffnung **9** im lateralen Bereich der Referenzkammer links zu erkennen. Rechts neben der Illustration der Referenzkammer wird eine Draufsicht des ersten Bondmaterials **4,** bevorzugt Gold, dargestellt. Bondprozesse finden in einer Bondkammer statt, welche nicht abgebildet ist.

In **Fig. 2** **H** befindet sich die Referenzkammer nicht mehr in der Bondkammer, sondern in einer Beschichtungsanlage, vorzugsweise in einer PECVD - Anlage (Plasma-Enhanced Chemical Vapour Deposition). Dabei kann sich zunächst ein beliebiges Gas mit Raumdruck im Volumen **7** der Referenzkammer befinden, der in der **Fig. 2** **I** innerhalb der Beschichtungsanlage abgepumpt wird, sodass sich danach ein Vakuum im Volumen **7** der Referenzkammer befindet. Der Fachmann weiß, dass in der Realität ein Vakuum niemals absolut ist, sondern sich durch einen erheblich geringeren Druck gegenüber dem Atmosphärendruck bei Normalbedingungen auszeichnet.

In der **Fig. 2** **J** wird die Beschichtungsanlage mit dem Referenzgas **11** beflutet, sodass über die Öffnung 9 das Referenzgas **11,** z. B. Ammoniak, in das Volumen **7** der Referenzkammer gelangt. In der Fig. 2 K wird die Referenzkammer über eine Abdeckschicht **12,** insbesondere durch das Abscheiden eines Nitrids, innerhalb der Beschichtungsanlage hermetisch abgeriegelt, wodurch die Öffnung **9** auch zuverlässig verschlossen ist und daher das Referenzgas **11** nicht mehr aus der Referenzkammer entweichen kann.

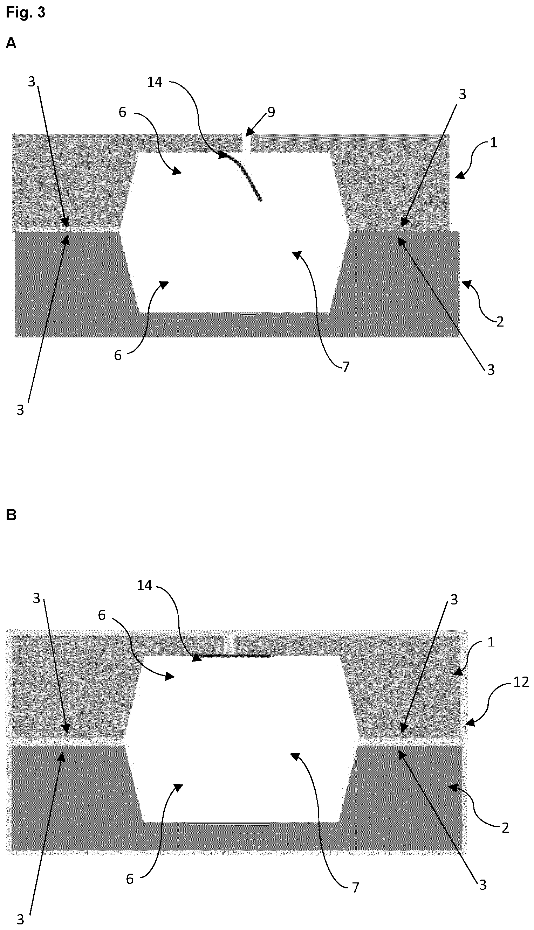

**Fig. 3** **A - B** zeigt eine zusammenfassende Darstellung einer zweiten Variante eines Herstellungsverfahrens, um eine mit Referenzgas **11** gefüllte Referenzkammer zu bilden. Der erste Wafer **1** und der zweite Wafer **2** werden bereitgestellt, wobei beide Wafer **1** und **2** erneut Kavitäten **6** aufweisen. Es befinden sich ein MEMS-Bauteil und/oder eine elektronische Schaltung auf dem ersten **1** und/oder dem zweiten Wafer **2,** z. B. innerhalb der Kavitäten **6.** Diese werden allerdings nicht abgebildet.

Nach dem Bonden der beiden Wafer **1** und **2** wird eine Öffnung **9** in den ersten **1** oder zweiten Wafer **2** geätzt. Ein Ventil **14** befindet sich am Ende der Öffnung **9.** Die beiden Wafer **1** und **2** werden miteinander derart gebondet, dass sich das Ventil **14** innerhalb des Volumens **7** der Referenzkammer am Ende der Öffnung **9** befindet. Bevorzugt wird das Ventil **14** am ersten **1** oder dem zweiten Wafer **2** vor dem Bondprozess angebracht. Beim Bonden selbst werden hingegen die Kontaktflächen **3** durchgängig zum Bonden des ersten Wafers **1** mit dem zweiten Wafer **2** verwendet. Nach dem Bonden des ersten Wafers **1** mit dem zweiten Wafer **2** wird die Referenzkammer aus der Bondkammer in die Beschichtungsanlage gebracht und dort mit dem Referenzgas **11** beflutet, wobei das Referenzgas **11** über die Öffnung **9** und über das Ventil **14** in das Volumen **7** der Referenzkammer gelangt.

Schließlich wird mit der Abdeckschickt **12,** vorzugsweise mit einer Nitridabscheidung, die Referenzkammer hermetisch abgeriegelt, bevorzugt über den gesamten Bereich der Referenzkammer.

Dieses Herstellungsverfahren ist besonders bevorzugt, wenn zum Auftragen der Abdeckschicht **12** ein vom Referenzgas **11** verschiedenes Prozessgas eingesetzt wird. Vorteilhafterweise verschließt das Ventil **14** bereits vor dem Beschichten mit der Abdeckschicht **12** das Referenzgas **11** innerhalb der Referenzkammer, sodass ein etwaiger Gasaustausch (von Referenzgas zu Prozessgas) zu keiner Kontamination führen kann.

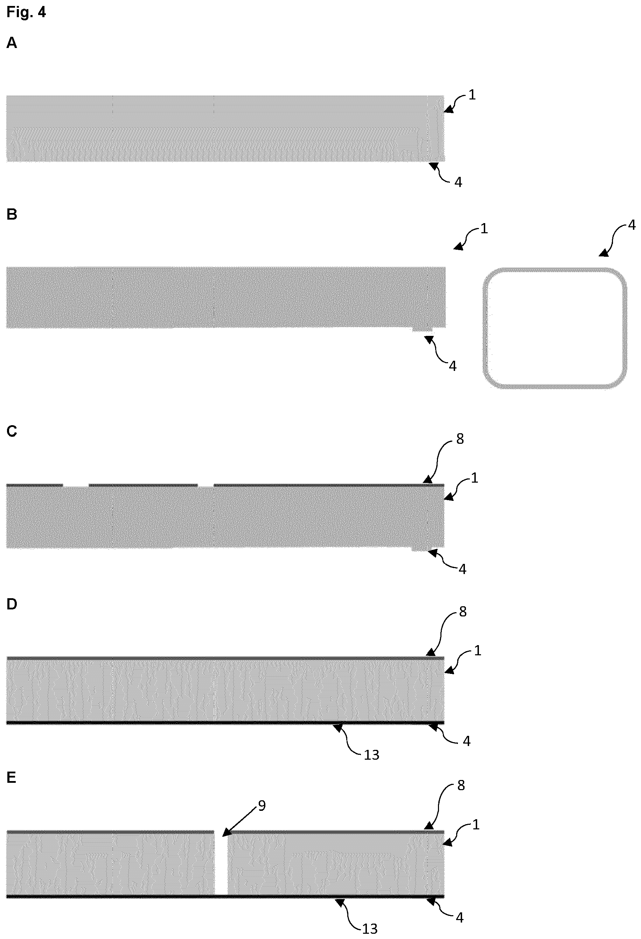

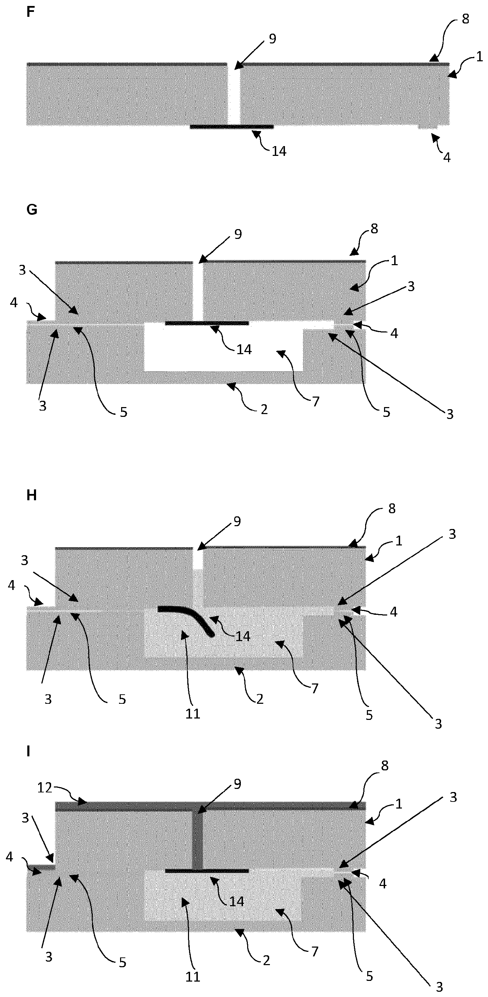

**Fig. 4** **A - I** zeigen bevorzugte Verfahrensschritte der zweiten Variante eines Herstellungsverfahrens einer mit Referenzgas **11** gefüllten Referenzkammer.

In **Fig. 4** **A** wird der erste Wafer **1** mit einem ersten Bondmaterial **4** rückseitig aufgetragen. Vorzugsweise ist das erste Bondmaterial **4** Gold und wird über ein Sputterverfahren auf die Rückseite des ersten Wafers **1** beschichtet.

In **Fig. 4** **B** wird das erste Bondmaterial **4** auf der Rückseite des ersten Wafers **1** strukturiert. Rechts ist eine Draufsicht des ersten Bondmaterials **4** illustriert. In Fig. 4 C wird ein Fotolack **8** auf der Vorderseite des ersten Wafers **1** aufgetragen. In Fig. 4 D wird eine Materialschicht **13** auf die Rückseite des ersten Wafers **1** aufgetragen. Bevorzugt wird dabei als Materialschicht **13** ein Weichmetall, besonders bevorzugt Aluminium, als eine Dünnschicht über ein Sputterverfahren auf die Rückseite des ersten Wafers **1** aufgetragen. In Fig. 4 E wird ausgehend von der Vorderseite des ersten Wafers 1 eine Öffnung **9** über ein Ätzprozess, vorzugsweise über ein Trockenätzprozess, gebildet. Dabei wird die Öffnung **9** bis zur Materialschicht **13** geätzt. Anschließend wird in Fig. 4 F die Materialschicht **13** zu einem biegsamen Ventil **14** strukturiert.

In **Fig. 4** **G** wird der erste Wafer **1** mit einem zweiten Wafer **2** gebondet, bevorzugt über ein TC - Bonden (s.o.). Das zweite Bondmaterial **5** auf den Kontaktflächen **3** des zweiten Wafers **2** kann bevorzugt Gold, Kupfer und/oder Aluminium sein. In **Fig. 4** **H** wird die Referenzkammer innerhalb einer Beschichtungsanlage, bevorzugt innerhalb einer PECVD - Anlage, über die Öffnung **9** mit dem Referenzgas **11** beflutet, wobei sich beim Einführen des Gases das Ventil **14** öffnet. In **Fig. 4** **I** wird die Referenzkammer über eine Abdeckschicht **12,** bevorzugt über ein Nitrid, hermetisch abgeriegelt.

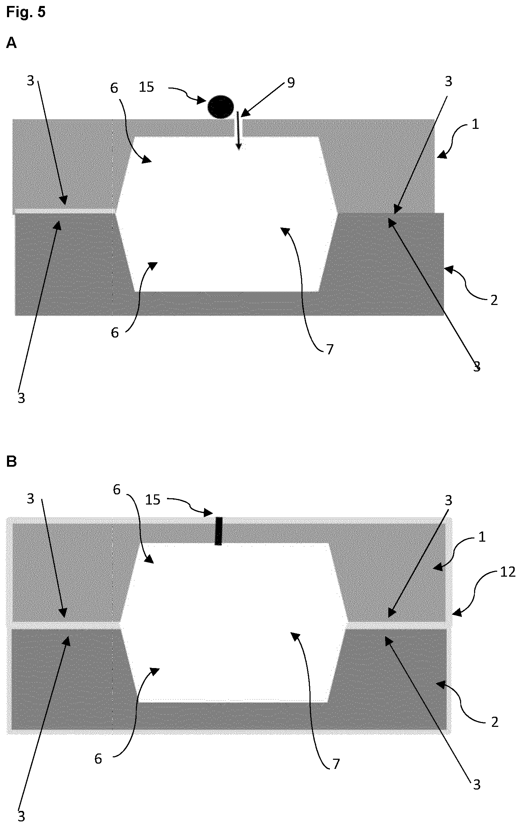

**Fig. 5** **A - B-** zeigt eine zusammenfassende Darstellung einer dritten Variante eines Herstellungsverfahrens. Auch in dieser dritten Varianten weisen die beiden Wafer **1** und **2** Kavitäten **6** auf, in die ein MEMS - Bauteil und/oder eine elektronische Schaltung eingefügt vorliegen kann. Das MEMS - Bauteil und/oder die elektronische Schaltung sind nicht abgebildet. Die beiden Wafer **1** und **2** werden bevorzugt an allen Kontaktflächen **3** miteinander in einer Bondkammer gebondet.

Vorzugsweise wird die Öffnung **9** vor dem Bonden über ein Ätzverfahren, bevorzugt Trockenätzen, gebildet. Nach dem Bonden der beiden Wafer **1** und **2** wird ein Lot **15** in die Nähe der Öffnung **9** platziert. Nach dem Einführen des Referenzgases **11,** z. B. Ammoniak, in das Volumen **7** der Referenzkammer innerhalb der Beschichtungsanlage, wird das Lot **15** geschmolzen, sodass es in die Öffnung **9** hineinfließt. Durch das Schmelzen und das Hineinfließen des Lotes wird die Öffnung **9** verschlossen. Über eine Abdeckschicht **12,** vorzugsweise ein Nitrid, wird die Referenzkammer hermetisch abgeriegelt.

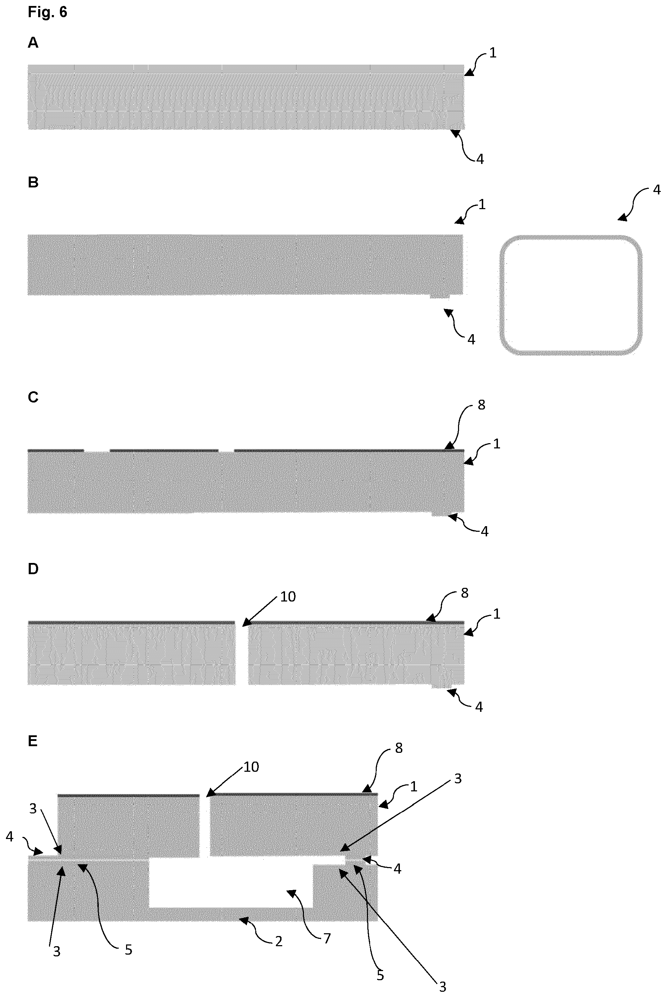

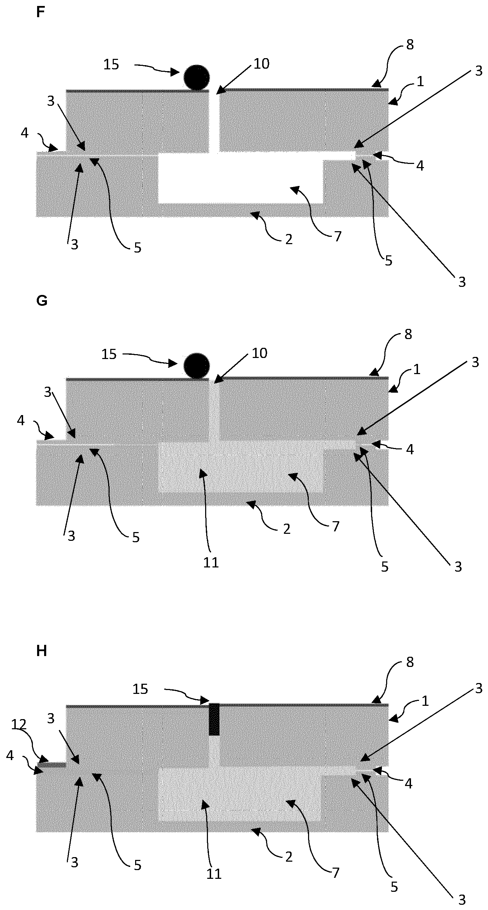

**Fig. 6** **A - H** zeigt bevorzugte Verfahrensschritte der dritten Variante eines Herstellungsverfahrens einer mit Gas gefüllten Referenzkammer. In **Fig. 6** **A** wird der erste Wafer **1** bereitgestellt und mit dem ersten Bondmaterial **4** auf seiner Rückseite beschichtet. Vorzugsweise ist das erste Bondmaterial **4** Gold und wird auf die Rückseite des ersten Wafers **1** über ein Sputterverfahren angebracht. In **Fig. 6** **B** wird das erste Bondmaterial **4** auf der Rückseite des ersten Wafers **1** strukturiert.

Rechts ist eine Draufsicht der Strukturierung des ersten Bondmaterials **4** illustriert. In **Fig. 6** **C** wird ein Fotolack **8** auf der Vorderseite des ersten Wafers **1** angebracht. In **Fig. 6** **D** wird ausgehend von der Vorderseite eine Öffnung **9** über ein Ätzprozess, bevorzugt über ein Trockenätzverfahren, besonders bevorzugt über reaktives lonentiefätzen, in den ersten Wafer **1** gebildet. In **Fig. 6** **E** wird ein zweiter Wafer **2** mit dem ersten Wafer **1** an den Kontaktflächen **3** gebondet. Der zweite Wafer umfasst an den Kontaktflächen **3** ein zweites Bondmaterial **5,** was bevorzugt Gold, Kupfer und/oder Aluminium ist.

Vorzugsweise werden die beiden Wafer **1** und **2** über TC - Bonden miteinander gebondet. Nach dem Bondprozess wird in Fig. 6 F ein thermisches Lot **15** in die Nähe der Öffnung **9** angebracht. Anschließend wird in Fig. 6 G die Referenzkammer innerhalb der Beschichtungsanlage mit dem Referenzgas **11,** z. B. Ammoniak, beflutet. Schließlich wird in **Fig. 6** **H** das thermische Lot **15** geschmolzen, um in die Öffnung **9** zu fließen und es verschließen.

Des Weiteren wird die Referenzkammer mit einer Abdeckschicht **12,** bevorzugt ein Nitrid, beschichtet, sodass die Referenzkammer besonders gut hermetisch abgeriegelt ist.

### Bezugszeichenliste

- 1: Erster Wafer
- 2: Zweiter Wafer
- 3: Kontaktfläche
- 4: Erstes Bondmaterial
- 5: Zweites Bondmaterial
- 6: Kavität
- 7: Volumen
- 8: Fotolack
- 9: Öffnung
- 11: Referenzgas
- 12: Abdeckschicht
- 13: Materialschicht zur Strukturierung als Ventil
- 14: Ventil
- 15: Lot

### LITERATURVERZEICHNIS

Bonilla-Manrique, Oscar E., et al. "Sub-ppm-Level Ammonia Detection Using Photoacoustic Spectroscopy with an Optical Microphone Based on a Phase Interferometer." Sensors 19.13 (2019): 2890.
Peng, W. Y., et al. "High-sensitivity in situ QCLAS-based ammonia concentration sensor for hightemperature applications." Applied Physics B 122.7 (2016): 188.
Schilt, Stéphane, et al. "Ammonia monitoring at trace level using photoacoustic spectroscopy in industrial and environmental applications."Spectrochimica Acta Part A: Molecular and Biomolecular Spectroscopy 60.14 (2004): 3259-3268.
Stemme, Goran, and Edvard Kalvesten. "Micromachined gas-filled chambers and method of microfabrication." U.S. Patent No. 6,124,145. 26 Sep. 2000.

## Patentansprüche

1. Herstellungsverfahren für einen photoakustischen Gassensor umfassend eine mit Gas gefüllte Referenzkammer, innerhalb der ein MEMS-Bauteil und optional eine elektronische Schaltung vorliegt, umfassend die folgenden Schritte:
a) Bereitstellen eines ersten (1) und zweiten Wafers (2), wobei mindestens der erste Wafer (1) und/oder der zweite Wafer (2) eine Kavität (6) aufweist und wobei auf dem ersten (1) und/oder zweiten Wafer (2) das MEMS-Bauteil vorliegt, wobei das MEMS-Bauteil ein MEMS-Sensor ist,
b) Bonden des ersten Wafers (1) mit dem zweiten Wafer (2) innerhalb einer Bondkammer zur Bildung eines mit Referenzgas (11) befüllbaren Volumens (7), wobei nach dem Bonden an einer Kontaktfläche (3) der beiden Wafer eine Öffnung (9) verbleibt, oder vor oder nach dem Bonden eine Öffnung (9) in den ersten (1) und/oder zweiten Wafer (2) eingebracht wird,
c) Befluten eines Referenzgases (11) in die Referenzkammer über die Öffnung (9) innerhalb einer Beschichtungsanlage,
d) Verschließen der Öffnung (9) der Referenzkammer innerhalb der Beschichtungsanlage
e) Bereitstellen eines modulierbaren Emitters,
f) Anordnung der mit dem Referenzgas befüllten Referenzkammer und des modulierbaren Emitters, wobei die Referenzkammer im Strahlengang des Emitters vorliegt, sodass der Emitter mittels modulierbar emittierbarer Strahlung das Referenzgas in der Referenzkammer zur Ausbildung von Schalldruckwellen anregen kann, welche mit Hilfe des MEMS-Sensors detektierbar sind.

2. Herstellungsverfahren nach einem oder mehreren der vorherigen Ansprüche
**dadurch gekennzeichnet, dass**
das Referenzgas (11) korrosive und/oder explosive Gase umfasst, bevorzugt Methan, Propan, Propylen, Silan, Chlorsilan, Wasserstoff und/oder Sauerstoff, besonders bevorzugt Ammoniak.

3. Herstellungsverfahren nach einem oder mehreren der vorherigen Ansprüche
**dadurch gekennzeichnet, dass**
zur Einstellung eines Partialdruckes des Referenzgases (11) innerhalb der Referenzkammer zusätzlich ein inertes Gas, bevorzugt Stickstoff, über die Öffnung (9) in die Referenzkammer eingeführt wird.

4. Herstellungsverfahren nach einem oder mehreren der vorherigen Ansprüche
**dadurch gekennzeichnet, dass**
der erste Wafer (1) und der zweite Wafer (2) Kontaktflächen (3) aufweisen, die zum Bonden des ersten Wafers (1) mit dem zweiten Wafer (2) dienen, wobei zum Bilden der Öffnung (9) ein Bereich an Kontaktflächen (3) nicht gebondet wird und/oder nach dem Bonden an einer Kontaktfläche (3) der beiden Wafer eine Öffnung (9) verbleibt, wobei die Öffnung (9) einen Querschnitt von 1 µm² bis 1000 µm², bevorzugt 1 µm² bis 100 µm² und eine Länge von 1 µm bis 1000 µm, bevorzugt 10 µm bis 500 µm, aufweist.

5. Herstellungsverfahren nach einem oder mehreren der vorherigen Ansprüche
**dadurch gekennzeichnet, dass**
vor oder nach dem Bonden des ersten Wafers (1) mit dem zweiten Wafer (2) die Öffnung (9) ausgehend von einer Außenseite zu einer Innenseite des ersten Wafers (1) oder des zweiten Wafers (2) gebildet wird, bevorzugt mittels eines Ätzprozesses.

6. Herstellungsverfahren nach einem oder mehreren der vorherigen Ansprüche
**dadurch gekennzeichnet, dass**
am Ende der Öffnung (9) des ersten (1) oder des zweiten Wafers (2) ein Ventil (14) vorliegt, wobei sich das Ventil (14) bevorzugt nach dem Bonden des ersten Wafers (1) mit dem zweiten Wafer (2) am Ende der Öffnung (9) ausgehend von der Außenseite des ersten Wafers (1) oder des zweiten Wafers (2) und im Volumen (7) der Referenzkammer befindet und/oder
wobei das Ventil (14) bevorzugt ein Weichmetall, bevorzugt ein Nichteisenmetall ist ausgewählt aus der Gruppe umfassend Blei, Gold, Indium, Kupfer, Platin, Silber, Zink, Zinn und/oder deren Verbindungen, besonders bevorzugt Aluminium und/oder dessen Verbindungen.

7. Herstellungsverfahren nach einem oder mehreren der vorherigen Ansprüche
**dadurch gekennzeichnet, dass**
nach dem Bonden des ersten Wafers (1) mit dem zweiten Wafer (2) die Referenzkammer in der Beschichtungsanlage mit dem Referenzgas (11) beflutet wird, wobei das Gas über die Öffnung (9) und über das Ventil (14) in das Volumen (7) der Referenzkammer gelangt.

8. Herstellungsverfahren nach einem oder mehreren der vorherigen Ansprüche
**dadurch gekennzeichnet, dass**
nach dem Befluten des Referenzgases (11) in die Referenzkammer zum Verschließen der Öffnung (9) ein Lot (15) geschmolzen wird.
, wobei das Lot (15) bevorzugt ein schmelzbares Material umfasst ausgewählt aus der Gruppe umfassend Blei, Zinn, Zink, Silber, Kuper, deren Legierungen und/oder Verbindungen.

9. Herstellungsverfahren nach einem oder mehreren der vorherigen Ansprüche
**dadurch gekennzeichnet, dass**
das Verschließen der Öffnung (9) durch ein Beschichtungsverfahren innerhalb der Beschichtungsanlage, bevorzugt durch eine Sprühbeschichtung, Nebelbeschichtung und/oder Dampfbeschichtung erfolgt und/oder
die Beschichtungsanlage eine physikalische Beschichtungsanlage oder eine chemische Beschichtungsanlage, eine Niederdruck-chemische Beschichtungsanlage und/oder Epitaxie-Beschichtungsanlage, ist.

10. Herstellungsverfahren nach einem oder mehreren der vorherigen Ansprüche
**dadurch gekennzeichnet, dass**
zum Verschließen der Öffnung (9) innerhalb der Beschichtungsanlage eine Abdeckschicht (12) mindestens über einen Bereich der Öffnung (9) aufgetragen wird, wobei als Material für die Abdeckschicht (12) bevorzugt ein Nitrid, ein Oxid, ein Metall, und/oder ein Edelmetall verwandt wird.

11. Herstellungsverfahren nach einem oder mehreren der vorherigen Ansprüche
**dadurch gekennzeichnet, dass**
zum Verschließen der Öffnung (9) und zur Ausbildung einer Abdeckschicht (12) ein Prozessgas in der Beschichtungsanlage eingeführt vorliegt,
wobei das Prozessgas nach dem Befluten eines Referenzgases in die Referenzkammer eingeführt wird oder
wobei ein Material zur Ausbildung der Abdeckschicht (12) derart gewählt wird, dass das Referenzgas gleichzeitig als Prozessgas dienen kann.

12. Herstellungsverfahren nach einem oder mehreren der vorherigen Ansprüche
**dadurch gekennzeichnet, dass**
die elektronische Schaltung, einen Prozessor, einen Schalter, Transistoren, und/oder Transducer umfasst.

13. Herstellungsverfahren nach einem oder mehreren der vorherigen Ansprüche
**dadurch gekennzeichnet, dass**
das MEMS-Bauteil ein Schalldruckdetektor ist, wobei der Schalldruckdetektor bevorzugt einen kapazitiv oder optisch auslesbaren, piezoelektrischen, piezoresistiven und/oder magnetischen Balken und/oder ein kapazitives, piezoelektrischen, piezoresistives und/oder optisches Mikrofon umfasst.

14. Photoakustischer Gassensor umfassend
- einen modulierbaren Emitter,
- eine mit einem Referenzgas (11) befüllte Referenzkammer, wobei innerhalb der Referenzkammer ein MEMS-Sensor vorliegt,
wobei die Referenzkammer im Strahlengang des Emitters vorliegt, sodass der Emitter mittels modulierbar emittierbarer Strahlung das Referenzgas (11) in der Referenzkammer zur Ausbildung von Schalldruckwellen anregen kann, welche mit Hilfe des MEMS-Sensors detektierbar sind,
**dadurch gekennzeichnet, dass**
der photoakustischer Gassensor mit einem Verfahren gemäß der Ansprüche 1-15 hergestellt wurde.

15. Photoakustischer Gassensor gemäß dem vorherigen Anspruch
**dadurch gekennzeichnet, dass**
die Referenzkammer ein geschlossenes System bildet, welches mit dem Referenzgas (11) gefüllt ist und ein zu analysierendes Gas, vorzugsweise Umgebungsluft, im Strahlengang zwischen dem Emitter und der Referenzkammer vorliegt, sodass der Anteil des Referenzgases (11) im zu analysierenden Gas anhand der Ausbildung von Schalldruckwellen in der Referenzkammer messbar ist.

## Claims

1. A method of producing a photoacoustic gas sensor comprising a gas-filled reference chamber within which a MEMS component and optionally an electronic circuit are present, comprising the following steps:
a) providing a first (1) and a second wafer (2), wherein at least the first wafer (1) and/or the second wafer (2) have/has a cavity (6) and wherein the MEMS component is present on the first (1) and/or second wafer (2), wherein the MEMS component is a MEMS sensor,
b) bonding the first wafer (1) to the second wafer (2) within a bonding chamber to form a volume (7) that can be filled with reference gas (11), wherein, after the bonding, an opening (9) remains on a contact surface (3) of the two wafers, or an opening (9) is made in the first (1) and/or second wafer (2) before or after the bonding,
c) flooding a reference gas (11) into the reference chamber via the opening (9) within a coating system,
d) sealing the opening (9) of the reference chamber within the coating system
e) providing a modulable emitter,
f) arranging the reference chamber filled with the reference gas and the modulable emitter, wherein the reference chamber is present in the beam path of the emitter, so that the emitter can excite the reference gas in the reference chamber by means of modulably emittable radiation to form sound pressure waves that can be detected by means of the MEMS sensor.

2. The production method according to any one or more of the preceding claims,
**characterized in that**
the reference gas (11) comprises corrosive and/or explosive gases, preferably methane, propane, propylene, silane, chlorosilane, hydrogen and/or oxygen, particularly preferably ammonia.

3. The production method according to any one or more of the preceding claims,
**characterized in that**
an inert gas, preferably nitrogen, is additionally introduced into the reference chamber via the opening (9) to set a partial pressure of the reference gas (11) within the reference chamber.

4. The production method according to any one or more of the preceding claims,
**characterized in that**
the first wafer (1) and the second wafer (2) have contact surfaces (3) which serve for bonding the first wafer (1) to the second wafer (2), wherein, to form the opening (9), an area of contact surfaces (3) is not bonded and/or, after bonding, an opening (9) remains on a contact surface (3) of the two wafers, wherein the opening (9) has a cross section of 1 µm² to 1000 µm², preferably 1 µm² to 100 µm² and a length of 1 µm to 1000 µm, preferably 10 µm to 500 µm.

5. The production method according to any one or more of the preceding claims,
**characterized in that**
before or after bonding the first wafer (1) to the second wafer (2), the opening (9) is formed starting from an outer side to an inner side of the first wafer (1) or the second wafer (2), preferably by means of an etching process.

6. The production method according to any one or more of the preceding claims,
**characterized in that**
a valve (14) is present at the end of the opening (9) of the first (1) or the second wafer (2), wherein, after bonding the first wafer (1) to the second wafer (2), the valve (14) is preferably located at the end of the opening (9) starting from the outside of the first wafer (1) or the second wafer (2) and in the volume (7) of the reference chamber, and/or
wherein the valve (14) is preferably a soft metal, preferably a non-ferrous metal selected from the group comprising lead, gold, indium, copper, platinum, silver, zinc, tin and/or compounds thereof, particularly preferably aluminum and/or compounds thereof.

7. The production method according to any one or more of the preceding claims,
**characterized in that**
after bonding the first wafer (1) to the second wafer (2), the reference chamber in the coating system is flooded with the reference gas (11), wherein the gas enters the volume (7) of the reference chamber via the opening (9) and the valve (14).

8. The production method according to any one or more of the preceding claims,
**characterized in that**
after the reference gas (11) has been flooded into the reference chamber, a solder (15) is melted to seal the opening (9),
wherein the solder (15) preferably comprises a fusible material selected from the group comprising lead, tin, zinc, silver, copper, alloys and/or compounds thereof.

9. The production method according to any one or more of the preceding claims,
**characterized in that**
the opening (9) is sealed by a coating method within the coating system, preferably by spray coating, mist coating and/or steam coating, and/or
the coating system is a physical coating system or a chemical coating system, a low-pressure chemical coating system and/or an epitaxial coating system.

10. The production method according to any one or more of the preceding claims,
**characterized in that**
to seal the opening (9) within the coating system, a covering layer (12) is applied at least over a section of the opening (9), wherein a nitride, an oxide, a metal, and/or a noble metal is preferably used as the material for the covering layer (12).

11. The production method according to any one or more of the preceding claims,
**characterized in that**
to seal the opening (9) and to form a covering layer (12), a process gas is introduced into the coating system,
wherein the process gas is introduced into the reference chamber after flooding with a reference gas, or
wherein a material for forming the cover layer (12) is selected such that the reference gas can simultaneously serve as a process gas.

12. The production method according to any one or more of the preceding claims,
**characterized in that**
the electronic circuit comprises a processor, a switch, transistors and/or transducers.

13. The production method according to any one or more of the preceding claims,
**characterized in that**
the MEMS component is a sound pressure detector, wherein the sound pressure detector preferably comprises a capacitively or optically readable, piezoelectric, piezoresistive and/or magnetic bar and/or a capacitive, piezoelectric, piezoresistive and/or optical microphone.

14. A photoacoustic gas sensor, comprising
a modulable emitter,
a reference chamber filled with a reference gas (11), wherein a MEMS sensor is present within the reference chamber,
wherein the reference chamber is present in the beam path of the emitter, so that the emitter can excite the reference gas (11) in the reference chamber by means of modulably emittable radiation to form sound pressure waves which can be detected by means of the MEMS sensor,
**characterized in that**
the photoacoustic gas sensor was manufactured by a method according to claims 1-15.

15. The photoacoustic gas sensor according to the preceding claim
**characterized in that**
the reference chamber forms a sealed system which is filled with the reference gas (11), and a gas to be analyzed, preferably ambient air, is present in the beam path between the emitter and the reference chamber, so that the proportion of the reference gas (11) in the gas to be analyzed can be measured by means of the formation of sound pressure waves in the reference chamber.

## Revendications

1. Procédé de fabrication d'un capteur de gaz photoacoustique comprenant une chambre de référence remplie de gaz, à l'intérieur de laquelle est présent un composant MEMS et éventuellement un circuit électronique, comprenant les étapes suivantes :
a) Fourniture d'une première (1) et d'une seconde plaquette (2), dans lequel au moins la première plaquette (1) et/ou la seconde plaquette (2) comportent une cavité (6) et dans lequel le composant MEMS est présent sur la première (1) et/ou la seconde plaquettes (2), dans lequel le composant MEMS est un capteur MEMS,
b) Collage de la première plaquette (1) à la seconde plaquette (2) à l'intérieur d'une chambre de collage pour former un volume (7) qui peut être rempli de gaz de référence (11), dans lequel il reste une ouverture (9) sur une surface de contact (3) des deux plaquettes après collage, ou une ouverture (9) est pratiquée dans la première (1) et/ou la seconde plaquette (2) avant ou après le collage,
c) Inondation de la chambre de référence par un gaz de référence (11) via l'ouverture (9) à l'intérieur d'une installation de revêtement,
d) Fermeture de l'ouverture (9) de la chambre de référence à l'intérieur de l'installation de revêtement
e) Fourniture un émetteur modulable,
f) Disposition de la chambre de référence remplie du gaz de référence et de l'émetteur modulable, dans lequel la chambre de référence est présente dans le trajet du faisceau de l'émetteur, de sorte que l'émetteur peut stimuler le gaz de référence dans la chambre de référence pour former des ondes de pression acoustique au moyen d'un rayonnement pouvant être émis de manière modulable, lesquelles ondes peuvent être détectées à l'aide du capteur MEMS.

2. Procédé de fabrication selon une ou plusieurs des revendications précédentes,
**caractérisé en ce que**
le gaz de référence (11) comprend des gaz corrosifs et/ou explosifs, de préférence du méthane, du propane, du propylène, du silane, du chlorosilane, de l'hydrogène et/ou de l'oxygène, de manière particulièrement préférée de l'ammoniac.

3. Procédé de fabrication selon une ou plusieurs des revendications précédentes,
**caractérisé en ce que**
pour régler une pression partielle du gaz de référence (11) à l'intérieur de la chambre de référence, un gaz inerte, de préférence de l'azote, est, de plus, introduit dans la chambre de référence via l'ouverture (9).

4. Procédé de fabrication selon une ou plusieurs des revendications précédentes,
**caractérisé en ce que**
la première plaquette (1) et la seconde plaquette (2) ont des surfaces de contact (3) qui servent à coller la première plaquette (1) à la seconde plaquette (2), dans lequel une zone de surfaces de contact (3) n'est pas collée pour former l'ouverture (9) et/ou il reste une ouverture (9) sur une surface de contact (3) des deux plaquettes après le collage, dans lequel l'ouverture (9) présente une section transversale de 1 µm² à 1000 µm², de préférence de 1 µm² à 100 µm² et une longueur de 1 µm à 1000 µm, de préférence de 10 µm à 500 µm.

5. Procédé de fabrication selon une ou plusieurs des revendications précédentes,
**caractérisé en ce que**
avant ou après le collage de la première plaquette (1) à la seconde plaquette (2), l'ouverture (9) est formée en partant de l'extérieur vers l'intérieur de la première plaquette (1) ou de la seconde plaquette (2), de préférence au moyen d'un processus de gravure.

6. Procédé de fabrication selon une ou plusieurs des revendications précédentes,
**caractérisé en ce que**
à l'extrémité de l'ouverture (9) de la première (1) ou de la seconde plaquette (2) se trouve une valve (14), dans lequel la vanne (14) se trouve de préférence après que la première plaquette (1) a été collée à la seconde plaquette (2) à l'extrémité de l'ouverture (9) en partant de l'extérieur de la première plaquette (1) ou de la seconde plaquette (2) et dans le volume (7) de la chambre de référence et/ou
dans lequel la vanne (14) est de préférence un métal mou, de préférence un métal non ferreux, choisi dans le groupe comprenant le plomb, l'or, l'indium, le cuivre, le platine, l'argent, le zinc, l'étain et/ou leurs composés, de manière particulièrement préférée l'aluminium et/ou leurs composés.

7. Procédé de fabrication selon une ou plusieurs des revendications précédentes,
**caractérisé en ce que**
après avoir collé la première plaquette (1) à la seconde plaquette (2), la chambre de référence dans l'installation de revêtement est inondée par le gaz de référence (11), dans lequel le gaz parvient au volume (7) de la chambre de référence via l'ouverture (9) et via la vanne (14).

8. Procédé de fabrication selon une ou plusieurs des revendications précédentes,
**caractérisé en ce que**
après l'inondation de la chambre de référence par le gaz de référence (11), une soudure (15) est réalisée par fusion pour obturer l'ouverture (9),
dans lequel la soudure (15) comprend de préférence un matériau fusible choisi dans le groupe comprenant le plomb, l'étain, le zinc, l'argent, le cuivre, leurs alliages et/ou composés.

9. Procédé de fabrication selon une ou plusieurs des revendications précédentes,
**caractérisé en ce que**
l'ouverture (9) est obturée par un procédé de revêtement à l'itérieur de l'installation de revêtement, de préférence par un procédé de revêtement par pulvérisation, brumisation et/ou vaporisation, et/ou
l'installation de revêtement est une installation de revêtement physique ou une installation de revêtement chimique, une installation de revêtement chimique à basse pression et/ou une installation de revêtement épitaxial.

10. Procédé de fabrication selon une ou plusieurs des revendications précédentes,
**caractérisé en ce que**
pour obturer l'ouverture (9) à l'intérieur de l'installation de revêtement, une couche de recouvrement (12) est appliquée au moins sur une zone de l'ouverture (9), dans lequel le matériau utilisé pour la couche de recouvrement (12) est de préférence un nitrure, un oxyde, un métal et/ou un métal précieux.

11. Procédé de fabrication selon une ou plusieurs des revendications précédentes,
**caractérisé en ce que**
pour obturer l'ouverture (9) et former une couche de recouvrement (12), un gaz de traitement est introduit dans l'installation de revêtement,
dans lequel le gaz de traitement est introduit dans la chambre de référence après qu'elle a été inondée par un gaz de référence ou
dans lequel un matériau pour former la couche de recouvrement (12) est choisi de sorte que la gaz de référence peut servir simultatément de gaz de traitment.

12. Procérisé de fabrication selon une ou plusieurs des revendications précédentes,
**caractérisé en ce que**
le circuit électronique comprend un processeur, un commutateur, des transistors et/ou des transducteurs.

13. Procédé de fabrication selon une ou plusieurs des revendications précédentes,
**caractérisé en ce que**
le composant MEMS est un détecteur de pression acoustique, dans lequel le détecteur de pression acoustique comprend de préférence une barre piézoélectrique, piézorésistive et/ou magnétique à lecture capacitive ou optique et/ou un microphone capacitif, piézoélectrique, piézorésistif et/ou optique.

14. Capteur de gaz photoacoustique comprenant
- un émetteur modulable,
- une chambre de référence remplie d'un gaz de référence (11), dans lequel un capteur MEMS est présent à l'intérieur de la chambre de référence,
dans lequel la chambre de référence est présente dans le trajet du faisceau de l'émetteur, de sorte que l'émetteur peut stimuler le gaz de référence (11) dans la chambre de référence pour former des ondes de pression acoustique au moyen d'un rayonnement pouvant être émis de manière modulable, lesquelles ondes peuvent être détectées à l'aide du capteur MEMS,
**caractérisé en ce que**
le capteur de gaz photoacoustique a été fabriqué à l'aide d'un procédé selon les revendications 1 à 15.

15. Capteur de gaz photoacoustique selon la revendication précédente
**caractérisé en ce que**
la chambre de référence forme un système fermé qui est rempli du gaz de référence (11) et un gaz à analyser, de préférence l'air ambiant, est présent dans le trajet de faisceau entre l'émetteur et la chambre de référence, de sorte que la proportion du gaz de référence (11) dans le gaz à analyser peut être mesuré à l'aide de la formation d'ondes de pression acoustique dans la chambre de référence.
